(19) Europäisches Patentamt
European Patent Office
Office européen des brevets

(11) **EP 3 482 530 B1**

(12) **EUROPEAN PATENT SPECIFICATION**

(45) Date of publication and mention of the grant of the patent:
**07.10.2020 Bulletin 2020/41**

(21) Application number: **17737535.9**

(22) Date of filing: **04.07.2017**

(51) Int Cl.:
***H04L 12/10*** *(2006.01)*

(86) International application number:
**PCT/EP2017/066589**

(87) International publication number:
**WO 2018/007363 (11.01.2018 Gazette 2018/02)**

(54) **DETERMINATION OF THE RESISTANCE STRUCTURE OF AN ELECTRICAL CIRCUIT**

BESTIMMUNG DER WIDERSTANDSSTRUKTUR EINER ELEKTRISCHEN SCHALTUNG

DÉTERMINATION DE LA STRUCTURE DE RÉSISTANCE D'UN CIRCUIT ÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.07.2016 GB 201611968**

(43) Date of publication of application:
**15.05.2019 Bulletin 2019/20**

(73) Proprietor: **Canon Kabushiki Kaisha Tokyo 146-8501 (JP)**

(72) Inventors:
• **LE SCOLAN, Lionel**
  **35700 RENNES (FR)**
• **MERLET, Hervé**
  **35530 SERVON SUR VILAINE (FR)**
• **EL KOLLI, Yacine**
  **35000 Rennes (FR)**

(74) Representative: **Santarelli**
  **49, avenue des Champs-Elysées**
  **75008 Paris (FR)**

(56) References cited:
  **WO-A1-2015/029028      WO-A2-2008/100294**
  **US-B1- 8 930 729**

**Description**

FIELD OF THE INVENTION

The present invention relates in general to power over data cable systems, and in particular to a method and a device for determining the resistive structure of a cable segments of a power segment.

BACKGROUND OF THE INVENTION

In the past, analog video surveillance systems were generally installed in a star topology, wherein each camera is connected to a central point by its own cables, such as one cable for data transport and one cable for power distribution. Advantageously a single cable providing both data transport and power distribution, also known as "power over data cable" including PoE (Power over Ethernet) and PoC (Power over Coax) techniques, may be used to distribute the power from the central point to the surveillance cameras. Such power distribution over data cables is advantageous as a dedicated power network or expensive battery solutions are no longer required. This can be seen in detail in document US 8,930,729 B1 and also in document WO 2015/029028 A1.

When installing a new digital video surveillance system, the installer may use Local Area Network or LAN cables for power distribution. However, an installer upgrading or "retrofitting" an existing analog surveillance system to a digital video surveillance system may reuse some or all of the existing analog cable infrastructure.

Digital technologies exist that allow an existing cable to be extended in a "daisy chain topology" to receive new cameras. For large-scale existing surveillance systems, coaxial cables are often already in place. It is generally advantageous therefore to leave the existing cables in place and add new cameras. Implementation of coaxial-powered cameras in a daisy chain topology are based on a shared medium access control protocol (bus type), for instance such as Home-Plug AV protocol.

For conventional power over data cable systems, the power supply generally performs its own power budget management, thereby denying power to some cameras if the power budget is exceeded. However, this conventional approach, wherein the system is designed according to a "worst case" scenario, assumes that only one camera is coupled to a port of the power supply, with a limited cable length (typically 100 m, above which the data communication is not guaranteed) and the poorest cable resistance (that of the worst type of cable).

Nevertheless, in typical video surveillance systems, cables vary in specifications and lengths (often exceeding 500 m), with configurations that vary over time. The power budget management should therefore consider not only the power demand from each camera, but also the power dissipated by each of the cables used for connecting the cameras in the system, which requires the knowledge of the resistances of the cables employed. As the nature and length of the cables may vary significantly, to determine the resistance of each cable upon installation would require a time-consuming and costly characterization of each cable by the system integrator at set-up, and complemented upon each modification.

Therefore it seems to be particularly worthwhile to provide network cable characterization for power budget management.

SUMMARY OF THE INVENTION

The present invention has been devised to address at least one of the foregoing concerns, in particular to provide network cable characterization for power budget management.

According to a first aspect of the invention, there is provided method for enabling the determining of resistances of cable segments of a power segment according to claim 1.

Correspondingly, and according to a second aspect of the invention, there is provided a load adaptation device for enabling the determining of resistances of cable segments according to claim 14.

Combination of measurements effected by devices implementing the method and the exchange of measurement results by the communication means allows an easy and accurate computation of resistances of cable segments of the power segment.

Optional features of embodiments and variants of the invention are defined in the appended claims.

At least parts of the methods according to the invention may be computer implemented. Accordingly, the present invention may take the form of an entirely hardware embodiment, an entirely software embodiment (including firmware, resident software, micro-code, etc.) or an embodiment combining software and hardware aspects that may all generally be referred to herein as a "circuit", "module" or "system". Furthermore, the present invention may take the form of a computer program product embodied in any tangible medium of expression having computer usable program code embodied in the medium.

Since at least parts of the invention can be implemented in software, the present invention can be embodied as computer readable code for provision to a programmable apparatus on any suitable carrier medium, and in particular a suitable tangible carrier medium or suitable transient carrier medium. A tangible carrier medium may comprise a storage medium such as a floppy disk, a CD-ROM, a hard disk drive, a magnetic tape device or a solid state memory device and the like. A transient carrier medium may include a signal such as an electrical signal, an electronic signal, an optical signal, an acoustic signal, a magnetic signal or an electromagnetic signal, e.g. a microwave or RF signal.

BRIEF DESCRIPTION OF THE DRAWINGS

Other particularities and advantages of the invention will also emerge from the following description, illustrated by the accompanying drawings, in which:

- **Figure 1A** illustrates an example of a video surveillance system in which the invention may be implemented;
- **Figure 1B** is a functional block diagram of a power source equipment (PSE);
- **Figure 2A** is a functional block diagram of a camera according to an embodiment of the invention;
- **Figure 2B** illustrates a functional block diagram of a sensing unit that may be embedded in a camera;
- **Figure 3** presents a circuit for illustrating the concept of different cable resistance calculation methods;
- **Figure 4** is a high-level flowchart illustrating a method for determining the resistance structure of a power segment according to an embodiment of the present invention;
- **Figure 5** is a diagram showing a message exchange procedure between a master camera and slave camera;
- **Figure 6** illustrates the formats of messages to be exchanged according to **Figure 5;**
- **Figure 7** is a flowchart of a method implemented by a master camera to determine the resistance structure of a power segment according to an embodiment of the invention;
- **Figure 8** is a flowchart of a method implemented by a slave camera for determining the resistance structure of a power segment according to an embodiment of the present invention;
- **Figure 9** is a flowchart of a method implemented by cameras of a power segment for determining the resistance structure of the power segment according to one embodiment, also known as a "distributed" method;
- **Figure 10** shows a group of cameras comprising cameras according to embodiments of the invention (compatible cameras) and conventional cameras (non-compatible cameras);
- **Figure 11** represents a graph of current consumption versus cable length;
- **Figure 12** is a method of determining whether non-compatible cameras are present according to one embodiment;
- **Figure 13** is a functional block diagram of an integrated camera configured to implement embodiments of the invention; and
- **Figure 14** is a functional block diagram of a modular camera configured to implement embodiments of the invention.

DETAILED DESCRIPTION OF EMBODIMENTS OF THE INVENTION

Embodiments of the invention relate in general to the characterization of network cables for power budget management, in particular a method and cameras that do not require the intervention of an operator.

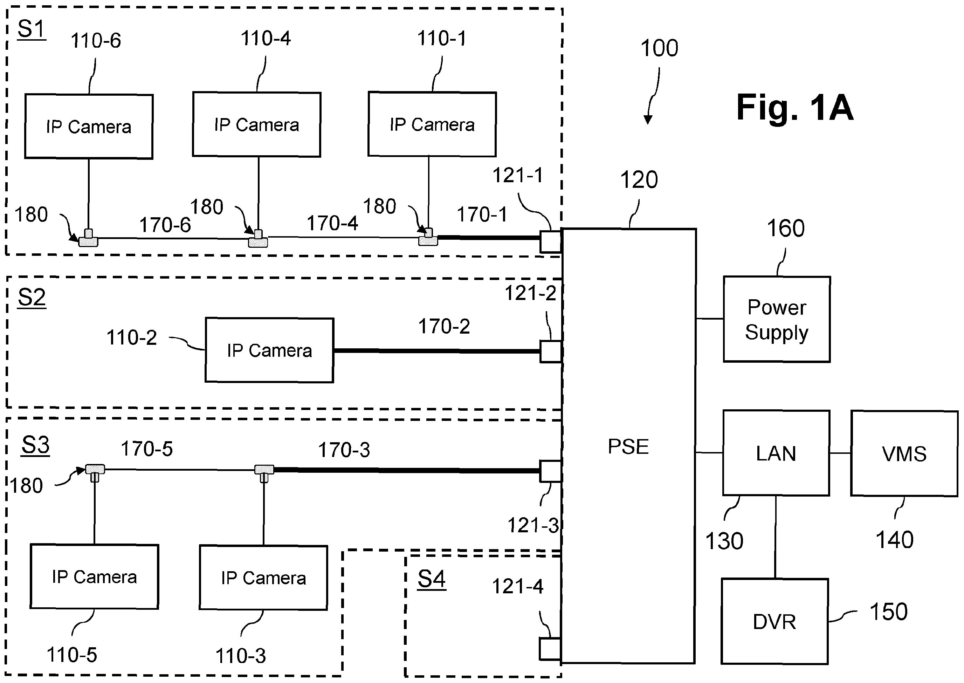

**Figure 1A** illustrates an example of a video surveillance system in which the invention may be implemented.

**Figure 1A** shows a retrofitted video surveillance system 100, that is to say, an analog video surveillance system that has been upgraded to IP (Internet Protocol) video. The system 100 comprises IP surveillance cameras 110-m (m being an index from 1 to M, M=6 in the illustrated example), hereinafter termed cameras for the sake of simplicity, a power source equipment or PSE 120 (also known as an "Ethernet over Coax receiver", "EoC receiver", or "IP over Coax receiver"), a Local Area Network or LAN 130, a Video Monitoring System or VMS 140, a Digital Video Recorder or DVR 150, and a power supply 160.

The cameras 110-m are linked to ports 121-n (n being an index from 1 to N, for example 4, 8, 16 etc., N=4 in the illustrated example) of the PSE 120 by cable segments 170-m, and may be either directly connected to a cable, or indirectly connected to a cable by means of a connector 180 used to extend the number of cameras connected to a main cable (shown in bold).

In this example configuration, main cable segments 170-1, 170-2, 170-3 were already present in the previous system to transport analog video signals. New digital cameras 110-1, 110-2, 110-3 replace the previous analog cameras and additional cameras 110-4, 110-5, and 110-6 have been added, each being coupled to the PSE 120 by new cable segments 170-4, 170-5, 170-6 respectively. Cameras 110-m and their associated ports 121-n are grouped into power segments Sn (n being the same index as of the port), a power segment thus being defined as all cameras, cable segments, connectors, etc. coupled to one port of the PSE.

Cameras 110-1, 110-4, 110-6 are indirectly coupled via connectors 180 to port 121-1 and form a first power segment S1; camera 110-2 is directly coupled to port 121-2 and forms a second power segment S2; cameras 110-3, 110-5 are indirectly coupled to port 121-3 and form a third power segment S3; and no cameras are coupled to port 121-4, which forms a fourth power segment S4.

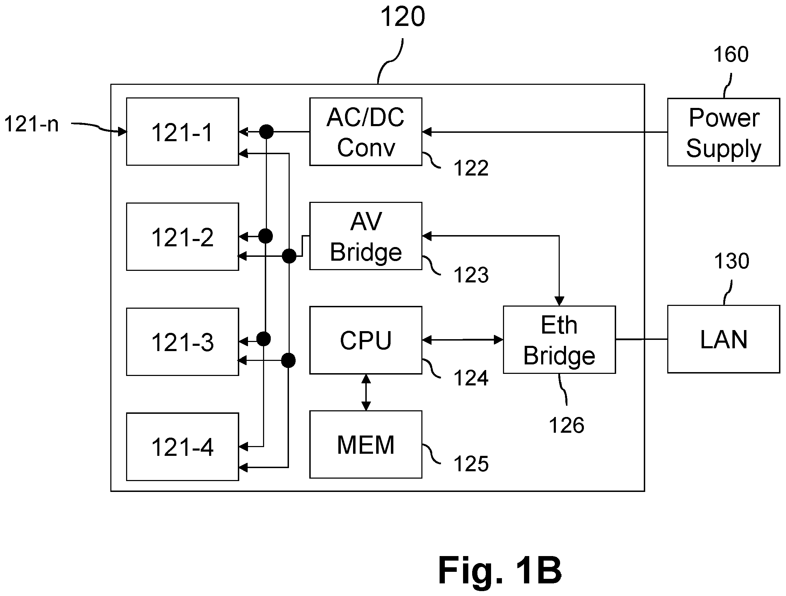

The cable segments 170-m can be 300 meters or longer and may be coaxial cables or any type of cable capable of transporting video. As described in more detail below in relation with **Figure 1B**, the PSE 120: 1) provides power to cable segments 170-m (and thus to cameras 110-m coupled thereto), 2) receives uplink IP LAN traffic from the LAN 130, encapsulates the traffic into packets suitable for digital data transport on the cables, and sends the packets on the cables, and 3) extracts IP LAN traffic from packets received on cable segments 170-m and forwards them to the LAN 130.

The LAN 130 includes switches, routers, and gateways that are necessary to transport the IP video to the VMS 140 and to the recorder 150. The VMS 140 is configured to display the IP video streams for surveillance purposes, and the recorder 150 is configured to record the IP video stream.

The advantage of power over data cable protocols is the possibility of linking (adding) several cameras to a main cable, for example cameras 110-4 and 110-6 linked to cable segment 170-1, and camera 110-5 linked to cable segment 170-3.

For camera surveillance applications, the main priority is the quality of service; that is to say, no interruption of power and data between a camera 110-m and the VMS 140 or the recorder 150.

For a group of cameras 110-m coupled to a PSE 120, the power is shared and is thus limited by the maximum power (PW_total) supplied by the power supply 160. Furthermore, power delivery is limited by the maximum power that could be supplied to each port (PW_port).

**Figure 1B** is a functional block diagram illustrating in further detail the PSE 120 of **Figure 1A**, such as a HomePlug AV PSE.

The PSE 120 comprises the plurality of N ports 121-n (here 121-1, 121-2, 121-3 and 121-4), an AC/DC converter 122, an audio/video AV bridge 123 (such as a HomePlug AV Bridge), a processor 124 (CPU), at least one memory 125, and an Ethernet bridge 126. The PSE 120 is coupled to the power supply 160 (such as a standard AC power output supplying 110 or 220 volts), to the LAN 130, and to the cable segments 170-m (not shown).

The converter 122 is thus coupled to the power supply 160 and converts the AC power received from the power supply 160 to DC power suitable for the cameras coupled to the PSE 120, for example to 48 or 56 volts, and is configured to handle power surges up to a maximum threshold, such as 250 Watt in this example. The converter 122 distributes the converted DC power to each port 121-n. Each port 121-n has its own power protection (not shown) to limit the amount of power that can be drawn by the cameras from the port, for example a maximum of 75 Watts per port. In this case, the converter 122 cannot handle a case where all ports draw the maximum power (75*4 = 300 Watts, which exceeds the threshold of 250 Watts).

The AV bridge 123 is responsible for encapsulating Ethernet traffic received from the Ethernet bridge 126 into HomePlug AV packets, for sending the packets on the cables coupled to the ports 121-n, for extracting IP traffic from received packets from the cables and for forwarding the extracted IP traffic to the Ethernet bridge 126.

The processor 124 exchanges messages with cameras by means of the Ethernet bridge 126 and may run control algorithms stored in the memory 125. The Ethernet bridge 126 is responsible for mixing IP traffic from the local area network LAN 130, the AV bridge 123, and the processor 124.

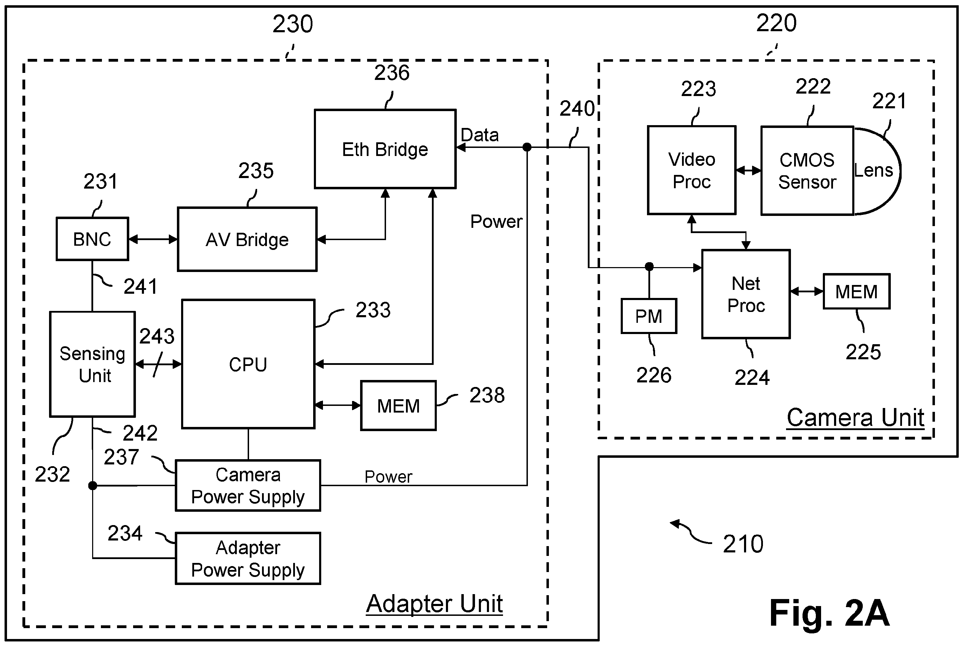

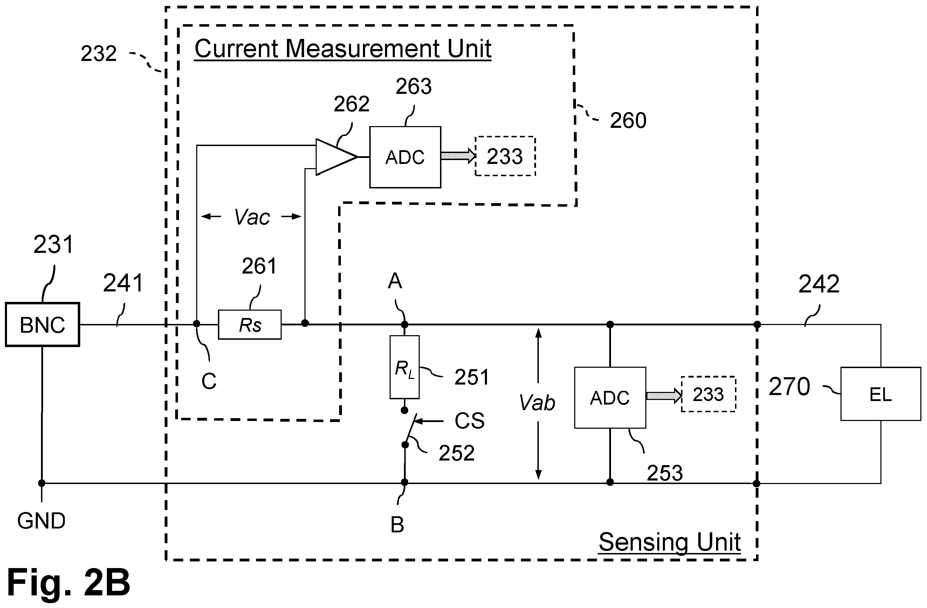

**Figures 2A** and **2B** are functional block diagrams of a camera comprising a sensing unit configured to implement cable resistance calculations according to embodiments of the invention, and of the sensing unit respectively.

**Figure 2A** shows details of a camera 210 according to one embodiment of the invention. Camera 210 is typically an IP camera that can be used in a video surveillance system; for example one or more cameras 110-m of the video surveillance system of **Figure 1A** may be of the type of camera 210.

According to first embodiments of the invention, all cameras 110-m of a given power segment Sn are considered of the type of camera 210. According to second embodiments of the invention, at least one camera 110-m in a power segment Sn is a conventional camera not implementing a cable resistance calculation method according to an embodiment of the present invention (e.g. not implementing sensing unit 232 described below). This conventional camera is called hereinafter "non compatible" camera, or NC camera. Only if otherwise stated, a camera referred to in the description is considered to be a compatible camera, i.e. implementing a cable resistance calculation method according to an embodiment of the present invention, such as camera 210.

Camera 210 comprises a conventional camera unit 220 (or "network camera") and an adapter unit 230 (or "terminal adapter") coupled by a cable 240, the cable 240 being for example an Ethernet link with Power over Ethernet capability for both data and power transmission.

The camera unit (network camera) 220 comprises a lens 221, a sensor 222 (for example, a CMOS sensor), a video processor 223, a network processor 224, at least one memory 225 (a non-volatile memory, a read-access-memory RAM, a Flash memory, etc.), and a power module PM 226 powering the camera unit 220 via the cable 240. The camera unit 220 thus provides the core device functions of image capture (optics), image processing and memory, and may thus be considered as the "functional unit" of the device.

The adapter unit (terminal adapter) 230 comprises a connector 231, a sensing unit 232, a processor 233 ("Central Processing Unit" or CPU), an adapter power supply module (subsystem DC/DC converter) 234, a camera power supply module 237, an audio/video AV bridge 235, an Ethernet bridge 236, and at least one memory 238.

The connector 231, for example a BNC port, couples the camera 210 to the PSE 120 (by means of the cable segments 170-m and any connectors 180), allows the IP communications such as HomePlug AV packets over coax cable, and provides power to the camera 210.

The sensing unit 232 is coupled on input to the connector 231 by means of a wire 241, receiving power thereby, and is coupled on output to the adapter power supply 234 and to the camera power supply 237 by means of a wire 242, supplying these latter with power. The sensing unit 232 is further coupled to the processor 233 by means of one or more wires 243 for the exchange of data.

The sensing unit 232 implements the cable resistance calculation method according to an embodiment of the present invention, as will be described in further detail with reference to the following figures. The sensing unit 232 sends measured sensing values to the processor 233 by means of the wire(s) 243, and receives commands from the processor 233 by means of the wire(s) 243.

The adapter power supply 234 powers the adapter unit 230, in particular a communication subsystem comprising the processor 233, the audio/video bridge 235, the Ethernet bridge 236, and the memory 238 (power connections not shown). The camera power supply 237 powers the camera unit 220 (more specifically, the power module PM 226) via the cable 240.

The AV bridge 235 ("Home Plug AV Bridge") encapsulates core camera IP traffic into HomePlug AV packets and sends them on the coax cable through the connector 231, and extracts IP traffic from received HomePlug AV packets and forwards this IP traffic to the camera unit 220. The Ethernet bridge 236 is coupled to the camera unit 220, the processor 233, and the AV bridge 235, receiving IP traffic from each and combining the IP traffic. The processor 233 exchanges messages with cameras of the same power segment and with the local camera unit 220 via the Ethernet bridge 236.

According to one or more embodiments, the processor 233 implements "Master Camera" and/or "Slave Camera" and/or "Distributed Camera" algorithms (described in more detail later) stored in the memory or memories 238 (for example a RAM memory), and determines the resistance structure of the power segment, which may also be stored in the memory or memories 238 (for example a non-volatile memory). The memory or memories 238 may be directly coupled to the processor 233, or coupled to a bus (not shown for the sake of simplicity).

According to another embodiment of the invention, the network processor 224 of the camera unit 220 implements "Master Camera" and/or "Slave Camera" and/or "Distributed Camera" algorithms (described in more detail later) stored in the memory or memories 225, and determines the resistance structure of the power segment, which may also be stored in the memory/memories 225. In the case of the Slave Camera or Distributed Camera algorithms, the control of the sensing unit 232 may still be managed by the processor 233.

**Figure 2B** illustrates a functional block diagram of the sensing unit 232 shown in **Figure 2A**, configured to implement a collaborative cable resistance calculation method according to embodiments of the invention.

The basis of the method is to measure the input voltage and/or current of the camera 210 in at least one operating condition. The measured values are used by a computing algorithm to calculate the resistance of various cable segments of a power segment.

As previously stated in relation with **Figure 2A**, the sensing unit 232 comprises a wire 241 coupling it to the connector 231 on input and a wire 242 coupling it to the adapter power supply 234 and to the camera power supply 237, as well as lines 243 coupling it to the processor 233. The remainder of the camera 210 is represented as an equivalent load (EL) 270 representing the total power consumption of the camera 210 (and the adapter unit).

The sensing unit 232 comprises a load resistance $R_L$ 251, a switch 252 (such as a transistor), an analog to digital converter 253, and a current measurement unit 260. The load resistance 251 and the switch 252 are in series between a node A and a node B of the circuit. The switch 252 is controlled by a control signal CS provided by processor 233 (represented in dotted lines). Activation of the switch 252 causes it to close, coupling the resistance 251 between the nodes A and B. Deactivation of the switch 252 causes it to open, de-coupling the resistance 251 from the nodes A and B. The converter 253 measures a voltage value Vab between the nodes A and B, and supplies a measured voltage value to the processor 233. Alternatively, the converter 253 may be integrated within the processor 233 and coupled by wires to the nodes.

The load resistance 251 is thus used to modify the operating condition of the camera 210 by increasing its power consumption. The resulting change in the operation of the camera can be predicted as the value of the load resistance 251 is known, and preferably with high precision (e.g. 1% accuracy). When the switch 252 is open (de-activated or OFF), such that the load resistance 251 is de-coupled, the loading mode is considered to be "unloaded". When the switch 252 is closed (activated or ON), coupling the load resistance 251, the loading mode is considered to be "loaded". The control signal CS controlling the state of switch 252 is managed by the processor 233 of the adapter unit 230 by means of the wire(s) 243.

The current measurement unit 260 is coupled to the input wire 241 and the output wire 242, and comprises a resistor $Rs$ 261, a differential amplifier 262, and an analog to digital converter 263. The current measurement unit 260 is connected to the input wire 241 at a node C and to the output wire 242 at node A of the sensing unit 232 and measures the input current of the camera 210. The resistor *Rs* 261 and the differential amplifier 262 are each coupled between nodes A and C. The differential amplifier 262 measures a voltage value *Vac* between nodes A and C; the measured voltage *Vac* divided by the known value of the resistor *Rs* 261 allows the input current of the camera 210 to be calculated. The measured voltage *Vac* is then supplied on input to the converter 263 and a digital value is supplied on output to the processor 233 (represented in dotted lines). Alternatively, the converter 263 may be directly integrated in the processor 233 and coupled to the output of the differential amplifier 262. The value of resistor *Rs* 261 is negligible, typically less than 1 Ohm, compared to the value of the resistances of the cable segments to be calculated, or else is taken into consideration for the cable resistance calculation as will now be described.

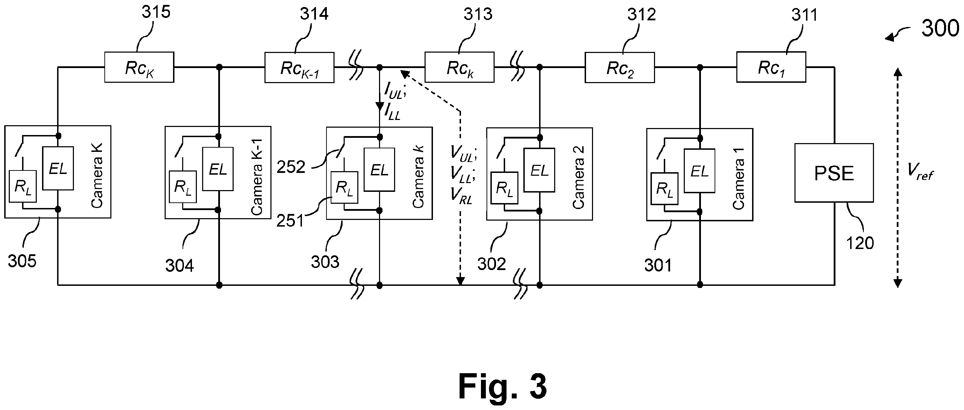

According to first embodiments of the invention, cable resistance calculation methods based on a collaborative approach are now described in further details in relation with **Figures 3 - 9.**

**Figure 3** presents a circuit for illustrating the concept of different cable resistance calculation methods.

**Figure 3** represents an equivalent electrical circuit 300 of a power segment, which could for example any one of power segments S1 - S4 of **Figure 1A**. The illustrated power segment comprises K cameras 301 - 305 of the type of camera 210, interconnected in a daisy-chained manner with cable segments, e.g. 170-m, having resistances 311 - 315 of values $Rc_k$, where $1 \leq k \leq K$ (index $k$ is assumed to increment from the camera closest to the PSE to the camera farthest from the PSE). The number of cameras in the power segment is kept here generic and equal to K. The number K may of course be different from one power segment to another. For example in the system illustrated in **Figure 1A**, K = 3 for power segment S1, K = 1 for power segment S2 and K = 2 for power segment S3.

It is assumed that the reference voltage $V_{ref}$ powering the circuit is known. The reference voltage, corresponding to the output voltage of the PSE for example, is assumed to be a fixed voltage, typically 56 V.

An unloaded voltage value $V_{UL}$ may be measured across each camera $k$, by the sensing unit 232 of camera $k$, when the corresponding load resistance $R_L$ 251 is de-coupled. This voltage value is also referred to as $V_{UL(k)}$. The term "unloaded" is used here in the sense that no load is present other than the camera load (*EL*). Also, an unloaded current value $I_{UL}$ may be measured crossing each camera $k$, by the sensing unit 232 of camera $k$, while in unloaded mode.

Similarly, a local loaded voltage value $V_{LL}$ may be measured across each camera $k$, by the sensing unit 232 of camera $k$, when the corresponding load resistance $R_L$ 251 is coupled. This voltage value is also referred to as $V_{LL(k)}$. Also, a local loaded current value $I_{LL}$ may be measured crossing each camera $k$, by the sensing unit 232 of camera $k$, while in loaded mode.

Furthermore, a remote loaded voltage value $V_{RL}$ may be measured across one camera $k1$, by the sensing unit 232 of camera $k1$, while the load resistance $R_L$ 251 of camera $k1$ is de-coupled (unloaded mode), but while the load resistance $R_L$ 251 of another camera $k2$ of the same power segment is coupled (loaded mode). This voltage value is also referred to as $V_{RL(k2, k1)}$.

All cameras can exchange their measured values using messages transmitted by the cameras' communication means.

First cable segment resistance calculation method (formula)

According to a first method of calculating the resistance of cable segments, the following formula is applied for calculating the resistance of cable segment $Rc_k$:

$$Rc_k = \left(\frac{R_L}{V_{LL(k)}}\right) * \left(V_{ref} - V_{LL(k)} - \left[\left(V_{ref} - V_{UL(k)}\right) * \frac{f(V_{LL(k)})}{f(V_{UL(k)})}\right]\right) - [Rc_{k-1} + \cdots + Rc_1]$$

As discussed above, $V_{UL(k)}$ is the voltage measured by camera $k$ while in unloaded mode (load resistance $R_L$ 251 deactivated by means of the switch 252), and $V_{LL(k)}$ is the voltage measured by camera $k$ while in loaded mode (load resistance $R_L$ 251 activated by means of the switch 252).

The function $f(V)$ represents the current consumption of a camera based on voltage and reflects the fact that a camera does not necessarily have a linear relationship between current and voltage.

Methods for determining the function $f(V)$ are known to a person skilled in the art. The function can be defined analytically, e.g. as a polynomial function, or digitally, e.g. by means of a lookup table.

In order for the method to be accurate, it is preferable that the definition of the function $f()$ and the measures of $V_{LL(k)}$ in view of determining $f(V_{LL(k)})$ are performed while the camera is in a same steady state, e.g. same operating mode (typically after the camera is started up, but before starting streaming).

It is assumed here that all cameras have the same consumption profile; but it is possible to define a function $f_k(V)$ specific to each camera $k$.

A recursive computation of the resistances of the cable segments is thus applied, i.e.:

$$Rc_1 = \left(\frac{R_L}{V_{LL(1)}}\right) * \left(V_{ref} - V_{LL(1)} - \left[\left(V_{ref} - V_{UL(1)}\right) * \frac{f(V_{LL(1)})}{f(V_{UL(1)})}\right]\right)$$

$$Rc_2 = \left(\frac{R_L}{V_{LL(2)}}\right) * \left(V_{ref} - V_{LL(2)} - \left[\left(V_{ref} - V_{UL(2)}\right) * \frac{f(V_{LL(2)})}{f(V_{UL(2)})}\right]\right) - [Rc_1]$$

$$\dots$$

$$Rc_K = \left(\frac{R_L}{V_{LL(K)}}\right) * \left(V_{ref} - V_{LL(K)} - \left[\left(V_{ref} - V_{UL(K)}\right) * \frac{f(V_{LL(K)})}{f(V_{UL(K)})}\right]\right) - [Rc_{K-1} + \dots + Rc_1]$$

Second cable segment resistance calculation method (formula)

A second alternate method of calculating the resistance of cable segments based on collaborative sensing is presented now. This second method provides more accurate than the first method.
One possible implementation of the second method is summarized in the following steps:

Step 1 - All cameras of the power segment are set into unloaded mode and during this mode each camera $k$ of the power segment measures by means of its sensing unit 232 the voltage $V_{UL(k)}$. This allows the determination of the unloaded voltage vector $\overline{V}_{UL}$:

$$\overline{V}_{UL} = \left(V_{UL(1)}, V_{UL(2)}, \dots, V_{UL(K)}\right)$$

Step 2 - One camera $k$ is set in loaded mode and all other cameras are set into unloaded mode and voltage measurements are performed while these modes are set across each camera of the power segment. This allows the determination of the following voltage vector:

$$\left(V_{RL(k,1)}, V_{RL(k,2)}, \dots, V_{RL(k,k-1)}, V_{LL(k)}, V_{RL(k,k+1)}, \dots, V_{RL(k,K-1)}, V_{RL(k,K)}\right)$$

Step 2 is repeated for $1 \le k \le K$ which leads to the construction of a matrix $M_{LL\_RL}$ which lines are formed by the K determined voltage vectors:

$$M_{LL\_RL} = \begin{pmatrix} V_{LL(1)} & \cdots & V_{RL(1,K)} \\ \vdots & V_{LL(k)} & \vdots \\ V_{RL(K,1)} & \cdots & V_{LL(K)} \end{pmatrix}$$

Step 3 - Resistances $Rc_k$ of each cable segment of the power segment are then calculated based on the measures of the unloaded voltage vector $\overline{V}_{UL}$ and the matrix $M_{LL\_RL}$ by applying the following [Equation 1]:

$$Rc_k$$
$$= \frac{\left(V_{UL(k)} - V_{LL(k)}\right) - Rc_1\left(\delta I_1 + \dots + \delta I_K + \frac{V_{LL(k)}}{R_L}\right) - \dots - Rc_{k-1}\left(\delta I_{k-1} + \dots + \delta I_K + \frac{V_{LL(k)}}{R_L}\right)}{\delta I_k + \dots + \delta I_K + \frac{V_{LL(k)}}{R_L}}$$

where, for $1 \le j \le K$ and $j \ne k$:

$$\delta I_j = f\left(V_{RL(k,j)}\right) - f\left(V_{UL(j)}\right)$$

and

$$\delta I_k = f\left(V_{LL(k)}\right) - f\left(V_{UL(k)}\right)$$

$\delta I_j$ represents the difference in current consumption of the camera $j$ when the camera $k$ switches from loaded mode to unloaded mode.

Thus resistance values can be calculated as follows:

$$Rc_1 = \frac{\left(V_{UL(1)} - V_{LL(1)}\right)}{\delta I_1 + \cdots + \delta I_K + \dfrac{V_{LL(1)}}{R_L}}$$

$$Rc_2 = \frac{\left(V_{UL(2)} - V_{LL(2)}\right) - Rc_1\left(\delta I_1 + \cdots + \delta I_K + \dfrac{V_{LL(2)}}{R_L}\right)}{\delta I_2 + \cdots + \delta I_K + \dfrac{V_{LL(2)}}{R_L}}$$

$$Rc_3 = \frac{\left(V_{UL(3)} - V_{LL(3)}\right) - Rc_1\left(\delta I_1 + \cdots + \delta I_K + \dfrac{V_{LL(3)}}{R_L}\right) - Rc_2\left(\delta I_2 + \cdots + \delta I_K + \dfrac{V_{LL(3)}}{R_L}\right)}{\delta I_3 + \cdots + \delta I_K + \dfrac{V_{LL(3)}}{R_L}}$$

etc.

Flowcharts for implementing the cable resistance calculation methods will now be described.

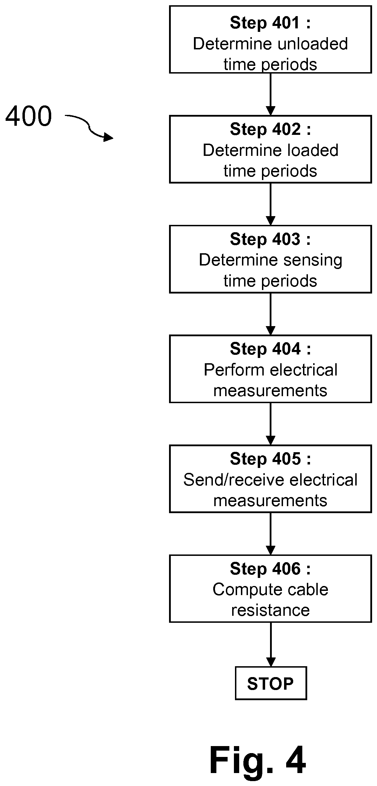

**Figure 4** is a high-level flowchart 400 illustrating a method for determining the resistance structure of a power segment according to an embodiment of the present invention. The method is particularly applicable to the implementation of the first cable segment resistance calculation method discussed above. The method comprises steps 401 to 406.

In step 401, at least one first time period or "unloaded time period" is determined for when the load resistance $R_L$ 251 of the sensing unit 232 of camera(s) 210 of a power segment (e.g. cameras 110-1, 110-4 and 110-6 of power segment S1 in **Figure 1)** is not activated, that is to say the switch 252 is open or OFF, such that the load resistance is not coupled. Only one camera of a power segment may determine the unloaded time period(s) for the other cameras of the power segment, each camera of a power segment may determine the unloaded time period(s) for itself, or another entity may determine the unloaded time periods for the cameras of the segment.

In step 402, at least one second time period or "loaded time period" is determined for when the load resistance $R_L$ 251 of the sensing unit 232 of camera(s) 210 of a power segment (e.g. cameras 110-1, 110-4 and 110-6 of power segment S1) is activated, that is to say a time period for which the switch 252 is closed or ON, such that the load resistance is coupled. Again, only one camera of a power segment may determine the loaded time period(s) for the other cameras of the power segment, each camera of a power segment may determine the loaded time period(s) for itself, or another entity may determine the loaded time periods for the cameras of the segment.

In step 403, at least one sensing time period is selected for each of the first and second time periods, to occur during the first and second (unloaded and loaded) time periods determined in steps 401 and 402. A sensing time period is a time period during which a given camera shall perform electrical measurements using its sensing unit 232. The electrical measurements are voltage measurements ($V_{UL(k)}$, $V_{LL(k)}$) in this embodiment of the invention. In other variants of resistance calculation methods, the electrical measurements may be voltage and current measurements, or other electrical measurements. Only one camera of a power segment may determine the sensing time period for each of the other cameras of the power segment, each camera of a power segment may determine the sensing time period for itself, or another entity may determine the sensing time periods for the cameras of the segment. The sensing time periods may be selected amongst previously determined loaded and unloaded time periods based on the voltage measurement schemes and associated cable resistance calculation schemes.

In step 404, the camera or cameras belonging to the power segment perform electrical measurements ($V_{UL(k)}$, $V_{LL(k)}$) during the sensing periods previously determined in step 403. During this electrical measurement process, the cameras of the power segment deactivate or activate the load resistance $R_L$ 251 based on the unloaded and loaded time periods determined in steps 401 and 402 respectively.

In step 405, the cameras of the power segment send the electrical measurements (among which $V_{UL(k)}$ and $V_{LL(k)}$) to at least one of the other cameras of the power segment, and may be sent to only one other camera, several other cameras, or all cameras of the power segment. If there is only one camera of the power segment, the camera may keep the measurements for its own calculations or send them to a master device. The cameras of a segment may have information concerning the cable resistances of other segments, for a global view of the system.

Finally, in step 406, the resistance value of each cable segment of the power segment, for example cable segments 170-1, 170-4, 170-6 of power segment S1 in **Figure 1,** is computed using the formulas described above in relation with **Figures 3.** The resistance value computation may be performed by only one camera of the power segment, or by each camera of the power segment.

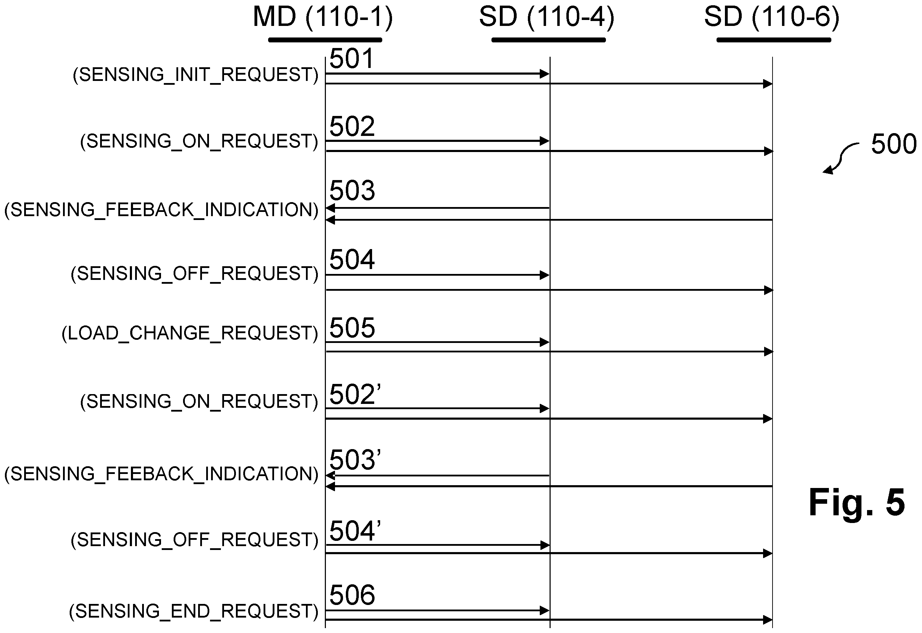

**Figure 5** is a diagram showing a message exchange procedure 500 between a Master Device MD (or "master camera") and Slave Devices SD (or "slave cameras"). In this example, the master device is camera 110-1, and the slave devices are cameras 110-4 and 110-6, for the sake of illustration only. The message exchange procedure 500 may apply to both first and second resistance calculation methods.

The master camera 110-1 sends an Initialize Sensing message 501 (SENSING_INIT_REQUEST) to the slave devices 110-4, 110-6 of the power segment S1 of **Figure 1.** The Initialize Sensing message 501 informs the receiving slave cameras of the start of a sensing sequence of a determined time period comprising either a time period with first loading mode and/or a time period with second loading mode and/or a sensing time period as illustrated by the flowchart 400 of **Figure 4.**

The master camera 110-1 then sends a first Start Sensing message 502 (SENSING_ON_REQUEST) to the slave cameras 110-4, 110-6. The first Start Sensing message 502 launches the start of a time period with the first loading mode (unloaded). Each slave camera of the first power segment S1 measures its input voltage (and/or current according to embodiments) using the sensing unit 232 as shown in **Figure 2B,** corresponding to step 404 of **Figure 4.**

The lapse of time between the sending/receiving of the Initialize Sensing message and that of the Start Sensing message allows the receiving cameras to perform any internal modifications that may be necessary, to prevent the appearance of any transitory phenomena, and for the system in general to stabilize before sensing is performed.

The slave cameras 110-4, 110-6 of the first power segment S1 respond to the first Start Sensing message 502 by sending a first Sensing Results message 503 (SENSING_FEEDBACK_INDICATION) comprising the unloaded electrical measurements as measured by the camera, corresponding to step 405 of **Figure 4.**

Upon reception of the first Sensing Results messages 503, the master camera sends a first Stop Sensing message 504 (SENSING_OFF_REQUEST) to the slave cameras. The first Stop Sensing messages 504 indicate the end of the sensing time period and the end of the unloaded time period. After receiving the first Stop Sensing messages 504, the slave cameras deactivate their load resistances $R_L$ 251 if not already deactivated, by ordering the switch 252 to OFF (open state).

Next, the master camera sends a first Load Change message 505 (LOAD_CHANG_REQUEST) to the slave cameras of the power segment, comprising an indicator (described below) that at least one of them should activate its load resistance $R_L$.

Then, the master camera sends a second Start Sensing message 502' to the slave cameras of the power segment, which then perform the electrical measurements and respond with a second Sensing Results message 503' comprising local or remote loaded measurements (e.g. $V_{LL(k)}$ and $V_{RL(k)}$) as measured by the camera. Following the reception of the feedback, the master camera sends a second Stop Sensing message 504' to the slave cameras of the power segment S1.

As previously, the lapse of time between the sending/receiving of the Load Change message and that of the Start Sensing message allows the receiving cameras to perform any internal modifications that may be necessary, in particular switching on of the switch, to prevent the appearance of any transitory phenomena, and for the system in general to stabilize before sensing is performed.

Furthermore, the Stop Sensing message allows the cameras to situate themselves within the sensing procedure.

Steps 505, 502, 503, 504, are repeated as necessary for remaining cameras of the power segment and then for the remaining power segments as necessary, for example, first camera 110-1 performs the local loaded measurement while the other cameras 110-4, 110-6 perform the remote loaded measurement, then camera 110-4 performs the local loaded measurement while the other cameras 110-1, 110-6 perform the remote loaded measurement, and then finally the camera 110-6 performs the local loaded measurement while the cameras 110-1, 110-4 perform the remote loaded measurements. In this case, the order of procedure is not necessarily important.

The master camera then sends a Sensing Finished message 506 (SENSING_END_REQUEST) to all slave cameras of the power segment. The master camera and/or slave cameras have received all the necessary electrical measurements needed to perform the cable resistance calculation method according to embodiments of the invention.

The lapse of time between the sending/receiving of the Stop Sensing message and that of the Sensing Finished message allows the receiving cameras to perform any internal modifications that may be necessary, in particular switching off of the switch for the camera that performed the load adaptation, to prevent the appearance of any transitory phenomena, and for the system in general to stabilize before returning to normal operation.

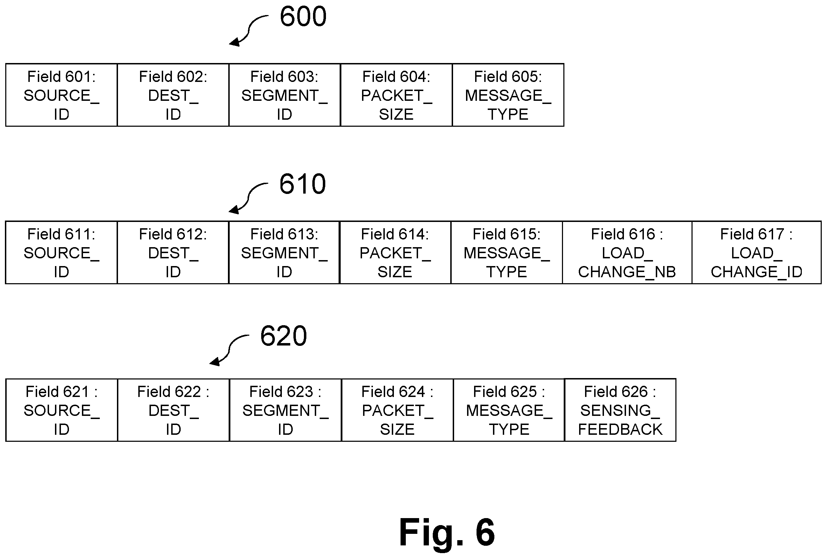

**Figure 6** illustrates the formats of messages 600, 610, 620 to be exchanged between the cameras belonging to a same power segment, according to one embodiment. In general (depending on the configuration of the communication network), all cameras of the network receive all messages circulating on the network.

Message 600 corresponds to a generic message format, such as may be used for the Initialize Sensing message 501 (SENSING_INIT_REQUEST), the Start Sensing message 502, 502' (SENSING_ON_REQUEST), the Stop Sensing message 504, 504' (SENSING_OFF_REQUEST), and the Sensing Finished message 506 (SENSING_END_REQUEST). The message format 600 comprises five fields 601 to 605.

Field 601 (SOURCE_ID) indicates the unique identifier ID of the camera sending the message 600, referred to as the source camera.

Field 602 (DEST_ID) indicates the unique identifier ID of the camera that should act upon (take into consideration) the message 600, referred to as the destination camera. In the case where the message 600 should be acted upon by all the cameras of a given power segment, all the bits of the field 602 may be set to the value '1' value for example, so as to indicate the broadcast nature of the message.

Field 603 (SEGMENT_ID) indicates the unique identifier of the power segment to which the destination camera belongs. In the case where all the bits of the field 602 are set to the value '1', all the cameras belonging to the power segment identified by the value of field 603 are destination cameras of the message 600.

Field 604 (PACKET_SIZE) indicates the size, typically in bytes, of the message 600.

Field 605 (MESSAGE_TYPE) indicates the nature of the message 600. For instance, assuming field 605 is an eight-bit field, its value may be set as follows:

- to 0x01 for a SENSING_INIT_REQUEST message 501;
- to 0x02 for a SENSING_ON_REQUEST message 502, 502';
- to 0x03 for a SENSING_OFF_REQUEST message 504, 504'; and
- to 0x04 for a SENSING_END_REQUEST message 506;

Thus, for messages of the message format 600, only the value of the MESSAGE_TYPE field 605 will vary from one type of message to another.

Message 610 corresponds to a message format such as may be used for the Load Change message 505 (LOAD_CHANGE_REQUEST). The message format 610 comprises eight fields 611 to 618.

Fields 611 to 615 correspond to fields 601 to 605. Field 615 (MESSAGE_TYPE) indicates the nature of the message 610; assuming field 615 is an eight-bit field, its value may be set to 0x05 for a LOAD_CHANGE_REQUEST message 505.

Field 616 (LOAD_CHANGE_NB) indicates the number of cameras that should activate their load resistance $R_L$; that is to say, those that should activate (close) their switch 252 upon reception of the message 610.

Field(s) 617 (LOAD_CHANGE_ID) indicates the unique identifier of the camera that should activate its load resistances $R_L$ upon reception of the message 610. The number of fields 617 depends on the number of cameras indicated in field 616.

Message 620 corresponds to a message format such as may be used for the Sensing Results message 503, 503' (SENSING_FEEDBACK_INDICATION). The message format 620 comprises six fields 621 to 626.

Fields 621 to 625 correspond to fields 601 to 605. Field 625 (MESSAGE_TYPE) indicates the nature of the message 620; assuming field 625 is an eight-bit field, its value may be set to 0x06 for a SENSING_FEEDBACK_INDICATION message 503, 503'.

Field 626 (SENSING_FEEDBACK) indicates the electrical measurement value measured by the camera following the reception of a SENSING_ON_REQUEST message. The field 626 may thus comprise a voltage value in Volts, or embed a voltage value in Volts and a current value in Amperes, or other implementation. In such a case, field 626 may be divided into two, or more, sub-fields.

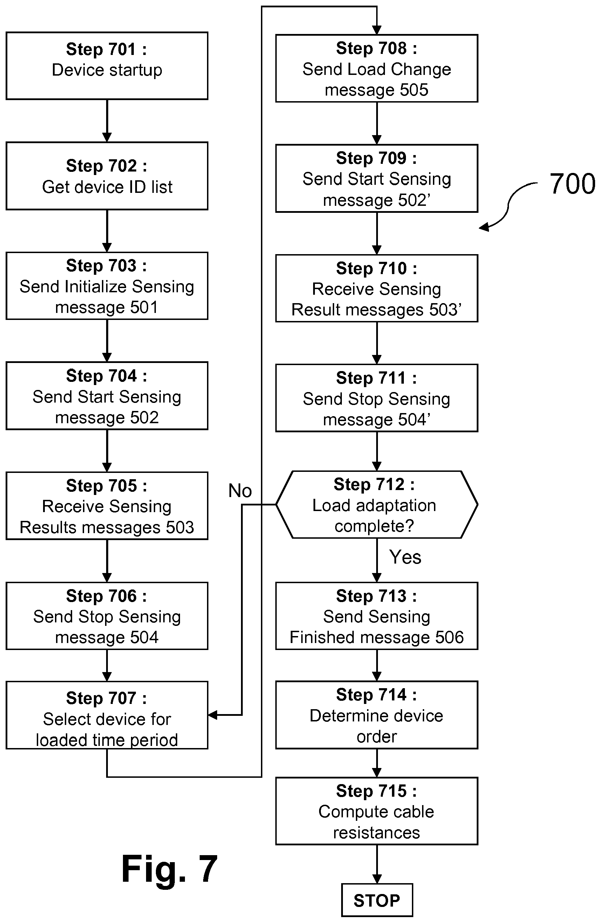

**Figure 7** is a flowchart 700 of a method implemented by a master camera to determine the resistance structure of a power segment according to an embodiment of the invention. The method is particularly applicable to the implementation of the second cable segment resistance calculation method discussed above. The flowchart is described with reference to system of **Figure 1** for illustration purpose only. The method 700 comprises the steps 701 to 715.

In step 701, camera start-up is performed. All cameras 110-m are connected and powered by a port 121-n of the PSE 120 via cables 170-m, connectors 180, and extensions. During start-up, the adapter units 230 of the cameras 110-m are powered, such that IP communication is enabled.

In step 702, the master camera determines, for each slave camera of a power segment, an identification ID list of the cameras coupled to the corresponding port 221-n of the segment by means of exchanging dedicated HomePlug AV packets for example. The master camera is determined according to predetermined criterion, such as the camera with the lowest camera identifier.

In step 703, the master camera sends the Initialize Sensing message 501 (SENSING_INIT_REQUEST) to the slave cameras of the first power segment S1, informing them of the start of the sensing sequence of a determined time period. It should be noted that the first segment is indicated here as being segment S1 for the sake of simplicity only. The first segment to perform the sensing method may be another segment, as necessary or convenient.

After waiting for all cameras of the power segment to be ready for the sensing sequence, in step 704, the master camera sends the first Start Sensing message 502 (SENSING_ON_REQUEST) to the slave cameras of the power segment, requesting unloaded electrical measurements (voltages $V_{UL(k)}$). This message determines the start of the unloaded time period (switch 252 is open, such that the load resistance $R_L$ is uncoupled). The slave cameras of the power segment perform the electrical measurements during the announced sensing periods. During this electrical measurement process, the cameras of the power segment do not activate the load resistance $R_L$ during the determined unloaded time periods.

In step 705, the master camera receives the first Sensing Results messages 503 (SENSING_FEEDBACK_INDICATION) sent by the slave cameras of the power segment, comprising the unloaded electrical (voltage) measurements ($\overline{V}_{UL}$).

In step 706, the master camera sends the first Stop Sensing messages 504 (SENSING_OFF_REQUEST) to the slave cameras of the power segment, ending the sensing time period and the first time period with first loading mode. Each slave camera receiving the first Stop Sensing message deactivates its load resistance $R_L$ if it is not already deactivated.

In step 707, the master camera selects a slave camera to be configured for a loaded time period, that is to say, to perform load adaptation by turning on the switch 252 to couple the load resistance $R_L$ 251 so to perform local load measurements $V_{LL}$, the other cameras of the power segment performing remote load measurements $V_{RL}$.

In step 708, the master camera sends the first Load Change message 505 (LOAD_CHANG_REQUEST) to the slave cameras, requesting local loaded electrical measurements (voltage $V_{LL}$) from the selected camera by activation of its load resistance $R_L$, and remote loaded electrical measurements (voltage $V_{RL}$) from the other cameras of the power segment. The Load Change message 505 also determines the start of the loaded time period.

In step 709, the master camera sends the second Start Sensing message 502' (SENSING_ON_REQUEST) to the slave cameras of the power segment, the message determining the start of a new sensing time period dedicated to the local and remote loaded measurements.

In step 710, after waiting for the selected slave camera to perform its load adaptation, and for the selected camera to perform its local load electrical measurement and the other (non-selected) camera(s) to perform its remote load electrical measurements, the master camera receives the second Sensing Results messages 503' (SENSING_FEEDBACK_REQUEST) from the slave cameras of the power segment, comprising the electrical measurements (voltages $V_{LL}$, $V_{RL}$).

In step 711, the master camera sends the second Stop Sensing message 504' (SENSING_OFF_REQUEST) to the slave cameras of the power segment; the slave camera(s) receiving the second Stop Sensing message 504' then deactivates its load resistance $R_L$ 251 if it is not already deactivated (for example, the previously-selected camera deactivates its load resistance, but the non-selected camera(s) already had its load resistance de-activated).

In step 712, the master camera determines whether the load adaptation is complete, that is to say, whether all cameras configured for a loaded time period have performed the load adaptation. If the response is No, then the method returns to step 707. If the response is Yes (either only one camera was configured to perform load adaptation, or all configured cameras have performed load adaptation), then the method proceeds to step 713.

In step 713, the master camera sends the Sensing End message 506 (SENSING_END_REQUEST) terminating the sensing sequence.

In step 714, the master camera determines the order of the cameras of the power segment from closest to the PSE to farthest from the PSE, for example by comparison of the unloaded voltage values $V_{UL}$ received from the cameras. In general, the camera with the highest unloaded voltage value $V_{UL}$ is the closest camera to the PSE, whereas the camera with the lowest unloaded voltage value $V_{UL}$ is the farthest camera from the PSE on the power segment, the other cameras being ordered accordingly depending on their unloaded voltage values. The ordering of the cameras may be used for the calculation of the cable resistances, as described in relation with **Figures 3.**

In step 715, the master camera calculates the cable segments resistances $Rc_k$ as described above in relation with **Figure 3**, and the method stops.

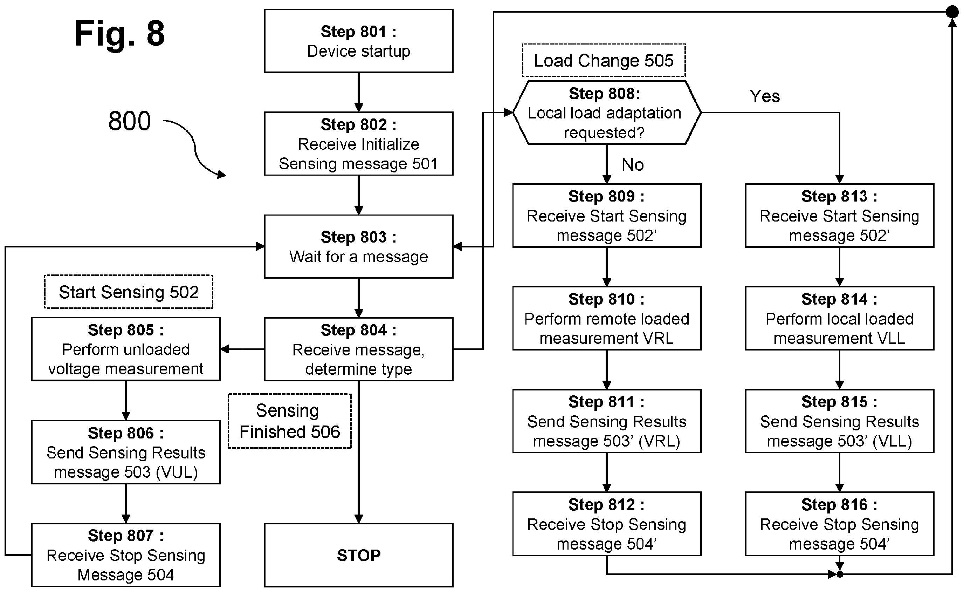

**Figure 8** is a flowchart of a method 800 implemented by a slave camera for determining the resistance structure of a power segment according to an embodiment of the present invention, in complement to the method 700 previously described. The method 800 comprises steps 801 to 816.

In step 801, a camera start-up step is performed wherein the slave cameras are connected and powered by a PSE port 121 via the cable segments. During start-up, the adapter units 230 of the slave cameras are powered and the communication subsystems are enabled, providing IP communication such as HomePlug AV packets transition over coax cable.

In step 802, the slave camera receives the Initialize Sensing message 501 (SENSING_INIT_REQUEST) sent by the master camera in step 703.

In step 803, the slave camera waits for a new message from the master camera. In step 804, a new message is received and analysed to determine what kind of message it is, depending on the message type field (Field 605, 615, 625). If the message is the Start Sensing message 502, the method goes to step 805. If the message is the Stop Sensing message 504, the method ends. If the message is the Load Change message 505, the method goes to step 807.

In step 805 (in the case where the received message was the Start Sensing message 502, determining the start of a time period with first loading mode where the load resistance $R_L$ is not coupled), the slave camera performs unloaded electrical measurements (voltage $V_{UL}$) during the announced sensing periods, wherein its load resistance $R_L$ is uncoupled during the unloaded time periods.

In step 806, the slave camera sends the unloaded electrical measurements (voltage $V_{UL}$) by means of the Sensing Results message 503 (SENSING_FEEDBACK_INDICATION) to the master camera. Then, in step 807, the slave camera receives the Stop Sensing message 504 (SENSING_OFF_REQUEST) from the master camera, ending the first time period, and the method returns to step 803, waiting for a new message.

In step 808 (in the case where the received message was the Load Change message 505 comprising the start of the second time period with the second loading mode), the slave camera determines whether it has been selected to activate its load resistance $R_L$ (by closing of the switch 252), for example by determining whether its camera identifier ID is in a field of the message according to message format 610. If the camera identifier of the slave camera receiving the message is not present, then a local load adaptation of the slave camera is not requested. Rather a local load adaptation of another slave camera is requested, such that the non-selected slave camera performs "remote load adaptation"; the method goes to step 809. Otherwise, if the camera identifier of the slave camera receiving the message is present, then the slave camera has been selected for local load adaptation, and the other cameras will perform remote load adaptation; the method goes to step 813.

In step 809, the slave camera receives the second Start Sensing message 502' from the master camera, indicating the start of the second sensing time period for local and remote voltage measurements $V_{LL}$ and $V_{RL}$. In step 810, the slave camera performs the remote voltage measurements (voltage $V_{RL}$), and in step 811, the slave camera sends the electrical measurements (voltage $V_{RL}$) to the master camera by means of the second Sensing Results message 503'. In step 812, the slave camera waits for the selected camera to stop performing local load adaptation, and receives a Sensing Off message 504' (SENSING_OFF_REQUEST), ending the loaded time periods of the slave cameras. The method then returns to step 803, waiting for a new message.

Otherwise, in the second case (selected for local load adaptation), the slave camera must perform local load adaptation by activating its load resistance $R_L$ 251. In step 813, the slave camera receives the new Start Sensing message 502' from the master camera, indicating the start of the second sensing time period (local and remote voltage measurements $V_{LL}$, $V_{RL}$). In step 814, the selected slave camera closes its switch 252, coupling the load resistance $R_L$ 251 for measurement of the local loaded voltage $V_{LL}$. In step 815, the slave camera sends the electrical measurements (local loaded voltage measurement $V_{LL}$) by means of the second Sensing Results message 503' to the master camera. In step 816, the slave camera receives the second Stop Sensing message 504' from the master camera, ending the loaded time period of the local slave camera, which thus deactivates its load resistance $R_L$ 251. The method then returns to step 803, waiting for a new message.

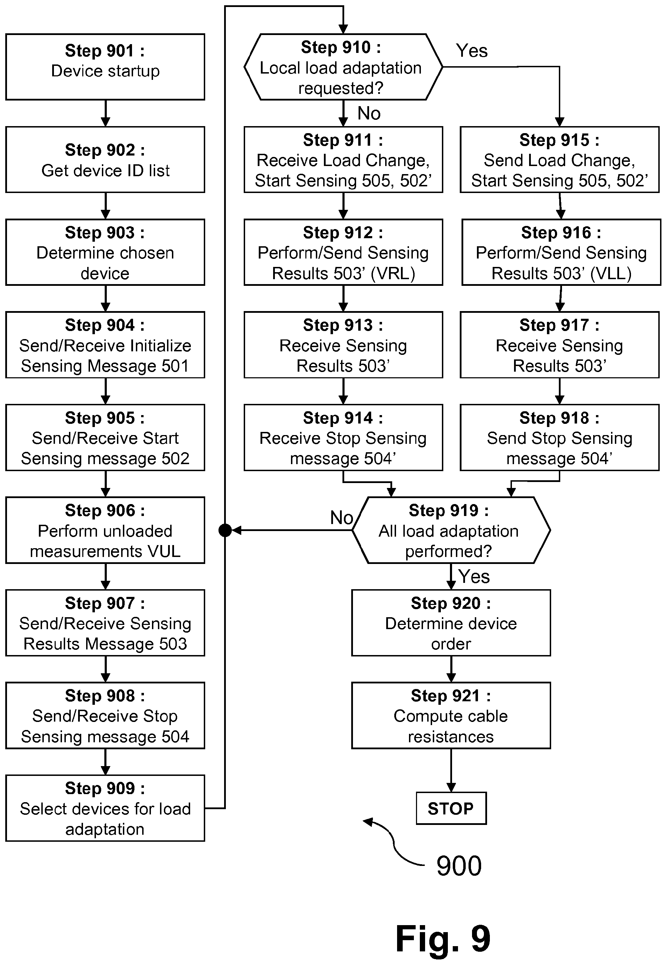

**Figure 9** is a flowchart of a method 900 implemented by cameras of a power segment for determining the resistance structure of the power segment according to an embodiment of the present invention, also known as a "distributed" method. The method 900 comprises steps 901 to 922.

In this embodiment, each camera determines its own unloaded, loaded, and sensing time periods, whether the electrical measurements should be performed and when, whether the load resistance $R_L$ should be activated or deactivated, as well performing the cable resistance calculations. The electrical measurements measured by a camera are sent to all the other cameras of the power segment.

In step 901, camera start-up is performed. All cameras 110-m are connected and powered by a port 121-n of the PSE 120 via cables 170-m, connectors 180, and extensions. During start-up, the adapter units 230 of the cameras 110-m are powered, such that IP communication is enabled.

In step 902, it is determined, for each camera of the power segment, a camera ID list of the cameras coupled to the same port 121-n of the PSE, forming a power segment, by means of data exchange.

In step 903, the cameras of the power segment choose a camera ("chosen camera") amongst them that will be in charge of sending the Initialize Sensing message 501. The choice of the camera may be done according to a predetermined rule, such as the camera with the lowest camera ID.

In step 904, the chosen camera sends the Initialize Sensing message 501 (SENSING_INIT_REQUEST) to the other ("not-chosen cameras") cameras of the power segment.

In step 905, after waiting for the other cameras to prepare for the sensing sequence, the chosen camera then sends the Start Sensing message 502 (SENSING_ON_REQUEST) to any or all cameras of the power segment.

In step 906, the camera or cameras that received the message 502 perform the unloaded electrical measurements (unloaded voltage $V_{UL}$) during the sensing periods announced in the Start Sensing message. During this step, no camera of the power segment activates its load resistance $R_L$ 251.

In step 907, each camera of the power segment sends the unloaded electrical measurements (unloaded voltage values $V_{UL}$) by means of the Sensing Results messages 503 (SENSING_FEEDBACK_INDICATION) to all the other cameras of the power segment (including the chosen camera).

In step 908, the chosen camera then sends the Stop Sensing message 504 (SENSING_OFF_REQUEST) to the other cameras of the power segment. Upon reception of the Stop Sensing message 504, the cameras deactivate their load resistance $R_L$ 251 if not already deactivated. The Stop Sensing message 504 signals the end of the unloaded time period, so that the cameras are prepared to perform the loaded time period.

In step 909, the cameras of the power segment select at least one camera to be configured for the loaded time period, for example by implementing, by each camera, an algorithm that choses the identifier with the lowest identifier, then the next lowest, etc.

In step 910, each camera of the power segment determines whether it has been selected to perform local load adaptation. If the response is no, then it next executes step 911, otherwise, if the response is yes, then it next executes step 915.

In the case where at step 910 the camera is not selected, in step 911, the non-selected camera waits for the reception of the Load Change message 505 (LOAD_CHANG_REQUEST) from the selected camera, so that all cameras of the segment may be synchronized, followed by the second Start Sensing message 502' from the selected camera, the Start Sensing message determining the start of the loaded time period for the selected camera.

In step 912, the non-selected camera performs remote loaded electrical measurements (remote loaded voltage $V_{RL}$), and then sends the electrical measurements to all the cameras of the segment as the second Sensing Results message 503'.

In step 913, the cameras of the power segment receive, from the other cameras of the power segment, the local and remote electrical measurements (local and remote loaded voltages $V_{LL}$, $V_{RL}$) by means of the Sensing Result messages 503'.

In step 914, the non-selected camera receives the second Stop Sensing message 504' from the selected camera. The method then proceeds to step 919.

In the case where at step 910 the camera is selected, in step 915, the selected camera sends the Load Change message 505 to the other, non-selected, cameras of the power segment, followed by the second Start Sensing message 502'.

In step 916, the selected camera performs the local loaded electrical measurement (local loaded voltage $V_{LL}$), and then sends the electrical measurement to the other cameras of the power segment as the second Sensing Results message 503'.

In step 917, the other non-selected cameras of the power segment send their electrical measurements (remote loaded voltage measurements $V_{RL}$) as the second Sensing Results messages 503' to the selected camera and to the other non-selected cameras.

In step 918, the selected camera stops the local load adaptation by deactivating its load resistance $R_L$, and then sends the second Stop Sensing message 504' to the other cameras of the power segment. The method then proceeds to step 919.

In step 919, each camera determines whether all cameras selected for load adaptation have indeed performed the load adaptation. If the response is no, then the method returns to step 910. Otherwise, if all cameras selected for load adaptation (either only one was selected, or else all have performed the load adaptation) have performed the load adaptation, then the Sensing Finished message 506 (sent for example by the last selected camera) may be sent, or else the method simply proceeds to step 920.

In step 920, each camera determines the order of the cameras of the power segment from closest to the PSE to farthest from the PSE, by comparison of the unloaded voltage values $V_{UL}$ received from the cameras. In general, the camera with the highest unloaded voltage value $V_{UL}$ is the closest camera to the PSE, whereas the camera with the lowest unloaded voltage value $V_{UL}$ is the farthest camera from the PSE on the power segment, the other cameras being ordered accordingly depending on their unloaded voltage values. The ordering of the cameras (index $k$) may be used for the calculation of the cable resistances, as described in relation with **Figure 3.** Alternatively, one camera, for example the last selected camera, could determine the order of the cameras and send the order to the other cameras.

In step 921, each camera calculates the cable resistances $Rc_k$ as described above in relation with **Figures 3**, and the method stops. In the case where some measurements are missing, preventing the calculation of the cable resistances, the method may be repeated for the missing measurements.

First embodiments of the invention described a method and system for determining the resistance structure - that is to say, the resistance of cables coupling various devices - of a system, in particular a video surveillance system comprising cameras, based on voltage measurements performed by each device and communicated between the devices. The total power consumption of the system, including the power dissipation resulting from non-negligible cable resistance, can be estimated. In order for the above method to fully function, all the devices of the system cooperate or collaborate, by performing voltage measurements and exchanging their measurement results.

However, it may happen that an unexpected power consumption occurs, for example replacing a device that has such capabilities with a device by another manufacturer that does not have such capabilities, by adding new devices that do not such capabilities, or by a device that ceases to have such capabilities (such as the sensing unit no longer working correctly). These devices (or cameras) are also referred to as "non compatible" devices (or cameras).

Furthermore, a simple passive power consumption phenomenon may result from abnormal cable behavior such as current leakage, electrical insulation default, cable degradation, and so forth. In this case, an unexpected "power sink" occurs, compromising the accuracy of the cable resistance calculation. It may therefore be desired to be able to calculate nevertheless the resistance of cable segments even in the case of a system comprising a mixture of compatible and non-compatible devices, as will now be described.

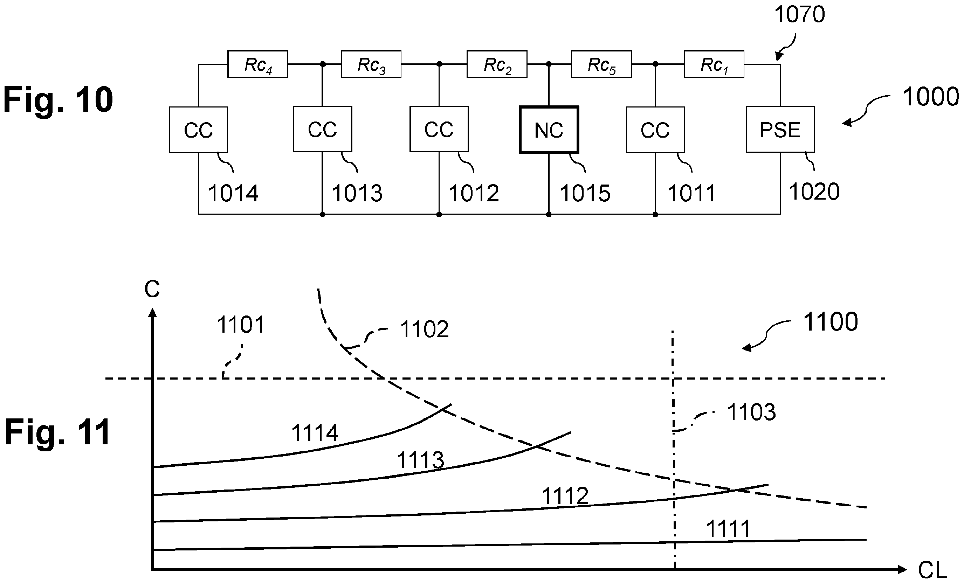

**Figures 10** - **12** are basis for describing second embodiments of the invention.

**Figure 10** shows a group 1000 of cameras, comprising four compatible cameras CC 1011, 1012, 1013, 1014 and one non-compatible camera NC 1015 (bold lines). The cameras, compatible and non-compatible, are coupled to a port of a PSE 1020 (schematically represented) by means of a coaxial cable 1070. The PSE 1020 generally has several ports (for example 4, 8, 16 or 24 ports), each port providing power to the coaxial cable segment by a DC power supply, for example 56 Volts.

A camera may be envisaged as a load consuming a power P. The camera may consume different amounts of power depending on whether the camera is in low power mode, e.g. only the adapter unit 230 is powered on, or high or normal power mode, e.g. the camera unit 220 is also powered on and operating. The cable 1070 has a resistance proportional to its length (for example 0.07 ohms per meter). The resistances are schematically represented as resistors $Rc_k$ for each segment of the cable ($Rc_1$, $Rc_2$, $Rc_3$, $Rc_4$, $Rc_5$) of the power segment. The first cable segment corresponding to resistance $Rc_1$ is generally the longest segment, for example 500 meters, and thus has the largest resistance; the other segments (corresponding to $Rc_2$, $Rc_3$, $Rc_4$, $Rc_5$) are generally, but not necessarily, shorter and have smaller resistances.

Each port of the PSE 1020 limits the current on the cable 1070 so as to avoid damages to either the cable or to the power supply, such as resulting from a short circuit or an over current in the case of too many cameras (nodes) simultaneously consuming significant amounts of power.

**Figure 11** represents a graph 1100 of current consumption C (y-axis) versus the cable length CL (x-axis). It may be seen from the graph that as the cable length CL increases, the current consumption C increases.

A current limitation 1101 (horizontal dashed line) may be fixed at a certain value, for example 0.9 Amperes, relating to the maximum current that may be supplied by the PSE on a port. Above the current limitation 1101 is a "forbidden current zone". If this limitation is reached, the PSE should cut the power supply of the corresponding PSE port, such that power is not supplied to the power segment.

A voltage drop resulting from the cable resistance times the current present in the cable (V = R * I) should also be considered. A camera needs a minimum voltage for start-up and for normal operation, for example a minimum voltage threshold of 36 volts according to a given standard (such as the power over Ethernet PoE standard). The minimum voltage threshold 1102 (curved dashed line), relating to the minimum voltage required by the camera and varying with the current consumption C, is also shown in **Figure 11.** Above the threshold 1102 is a "non-operational zone". Thus for example if the PSE supplies a voltage of 56 V, and the cable length and resistance are such that the voltage drop across the cable (for example 25 V) causes the device coupled to the cable to receive a voltage less than its minimum voltage threshold (56 V - 25 V = 31 V, which is less than a minimum voltage threshold of 36 V), then the camera can not operate.

A maximum cable length 1103 (vertical dot-dash line) is also shown relating to the maximum length of the first cable segment (between the PSE and the first camera of the power segment). This maximum cable length, for example 650 meters, is generally the longest authorized cable length, above which the devices have difficulty to communicate between themselves.

Four power consumption scenarios are given:

- a first scenario 1111 wherein only one camera is connected and powered on,
- a second scenario 1112 wherein two cameras are connected and powered on,
- a third scenario 1113 wherein three cameras are connected and powered on, and
- a fourth scenario 1114 wherein four cameras are connected and powered on.

In this example, only the cable resistance $Rc_1$ of the first segment is calculated, the other cable resistances ($Rc_2$, $Rc_3$, $Rc_4$) being considered as negligible. Furthermore, the typical camera power consumption is fixed at 7 Watts.

In the first and second scenarios 1111, 1112, the maximum cable length may be used, without risk that the cameras will be non-operational, since the scenario lines do not cross the voltage threshold 1102 before reaching the threshold 1103. However, for the third and fourth scenarios 1113, 1114 (and thus, by extrapolation, for more than four cameras), the cameras would enter into the non-operational zone before the maximum cable length is reached. Camera start-up would thus result in unstable camera behavior, for example a switch-on/switch-off loop sequence.

The vector $\overline{V}_{UL}$ and the matrix $M_{LL\_RL}$ described above in relation with **Figure 3** allow the cable resistances of cable segments between each of the cameras belonging to a same power segment to be computed.

With reference again to **Figure 10**, for K = 4 compatible cameras (1011, 1012, 1013, 1014 - hereinafter referenced C1, C2, C3, C4 respectively for simplicity) and for one non-compatible camera (1015 - hereinafter referenced C5 for simplicity), the computed values of the cable resistances $Rc_k$ ($Rc_1$, $Rc_2$, $Rc_3$, $Rc_4$, $Rc_5$) are given by Equation 1 discussed above for K=5 (including the non-compatible camera). Namely:

$$Rc_1 = (V_{UL(1)} - V_{LL(1)})/(\delta I_1 + \delta I_2 + \delta I_3 + \delta I_4 + \delta I_5 + V_{LL(1)}/R_L)$$

$$Rc_2 = \frac{\left(V_{UL(2)} - V_{LL(2)}\right) - Rc_1(\delta I_1 + \cdots + \delta I_5 + \frac{V_{LL(2)}}{R_L})}{\delta I_2 + \cdots + \delta I_5 + \frac{V_{LL(2)}}{R_L}}$$

$$Rc_3 = \frac{\left(V_{UL(3)} - V_{LL(3)}\right) - Rc_1(\delta I_1 + \cdots + \delta I_5 + \frac{V_{LL(3)}}{R_L}) - Rc_2(\delta I_2 + \cdots + \delta I_5 + \frac{V_{LL(3)}}{R_L})}{\delta I_3 + \cdots + \delta I_5 + \frac{V_{LL(3)}}{R_L}}$$

etc.

The term $\delta I_5$ is unknown since the non-compatible camera is unidentified and does not communicate with the compatible cameras. The first calculation of the cable resistance is therefore performed without considering the term $\delta I_5$.

Table 1 below shows a voltage matrix provided by simulation.

Table 1 : Simulated unloaded, local loaded, and remote loaded results

| $V_{UL(1)}$: 49.64676 | $V_{UL(2)}$: 45.13789 | $V_{UL(3)}$: 44.23116 | $V_{UL(4)}$: 44.07983 |
|---|---|---|---|
| $V_{LL(1)}$: 48.5243 | $V_{RL(1,2)}$: 43.91415 | $V_{RL(1,3)}$: 42.98641 | $V_{RL(1,4)}$: 42.83155 |
| $V_{RL(2,1)}$: 48.56644 | $V_{LL(2)}$: 42.32528 | $V_{RL(2,3)}$: 41.36656 | $V_{RL(2,4)}$: 41.2065 |
| $V_{RL(3,1)}$: 48.57947 | $V_{RL(3,2)}$: 42.35916 | $V_{LL(3)}$: 40.96196 | $V_{RL(3,4)}$: 40.80049 |
| $V_{RL(4,1)}$: 48.58344 | $V_{RL(4,2)}$: 42.36948 | $V_{RL(4,3)}$: 40.97408 | $V_{LL(4)}$: 40.66981 |

Table 2 below provides the resistance values $Rc_1$, $Rc_2$, $Rc_3$, $Rc_4$ as calculated using the matrix of Table 1 above, as well as the percent error of the computed values with respect to measured resistance values.

Table 2: Calculated cable resistance and percent error

| $Rc_1$: 21.63 | $Rc_2$: 35.00 | $Rc_3$: 10.50 | $Rc_4$: 3.50 |
|---|---|---|---|
| ERR1: -3.01% | ERR2: 0.01% | ERR3: 0.01% | ERR4: 0.01% |

It may be seen that the largest error is for the value of $Rc_1$, due to the unknown current value $\delta I_5$ of the non-compatible camera 1015 that passes through the cable segment comprising the resistance $Rc_1$.

Based on the Tables 1 and 2 above, the theoretical voltage across the compatible cameras CC without the non-compatible camera(s) NC may be calculated, as shown in Table 3 below.

Table 3: Measured and computed unloaded voltages

|  | Measured $V_{UL(k)}$ | Computed $V_{UL(k)}$ | Difference (Measured- Computed) |
|---|---|---|---|
| V0 | 56.00 | 53.30 | 2.70 |
| $V_{UL(1)}$ | 49.65 | 49.65 | 0.00 |
| $V_{UL(2)}$ | 45.14 | 45.14 | 0.00 |
| $V_{UL(3)}$ | 44.23 | 44.23 | 0.00 |

For the each line of Table 3, the equations providing the computed results (the second column Computed $V_{UL(k)}$) are as follows:

$$V_0 \; computed = Rc_1\big(I_{UL(1)} + I_{UL(2)} + I_{UL(3)} + I_{UL(4)}\big) + V_{UL(1)}$$

$$V_{UL(1)} \; computed = Rc_2\big(I_{UL(2)} + I_{UL(3)} + I_{UL(4)}\big) + V_{UL(2)}$$

$$V_{UL(2)} \; computed = Rc_3\big(I_{UL(3)} + I_{UL(4)}\big) + V_{UL(3)}$$

$$V_{UL(3)} \; computed = Rc_4\big(I_{UL(4)}\big) + V_{UL(4)}$$

The last column of Table 3 provides the difference between the computed unloaded voltage and the measured unloaded voltage by the compatible camera: $V_{UL(k)}$ measured - $V_{UL(k)}$ computed.

If the difference between measured and computed values exceeds a pre-defined threshold, such as for the first line of Table 3, then it may be concluded that a non-compatible camera is present and consuming power.

If there is no difference or difference less than the pre-defined threshold, such as for the second, third, and fourth lines of Table 3, then it may be concluded that there is no interposed non-compatible camera.

After detecting the presence of a non-compatible camera, its position "upstream" or "downstream" may be determined, and its current consumption can be estimated by the following equation:

$$I_5 = (\text{difference}(V_{UL(1)} \text{ measured} - V_{UL(1)} \text{ computed})) / Rc_1$$

It may be noted that the unloaded voltage values $V_{UL(k)}$ and the cable resistance $Rc_k$ employed for the calculation are those of the compatible camera determined to be the camera affected by the presence of the non-compatible camera, thus here the values for the camera C1 are employed.

Thus, for the above example, the difference $V_{UL(1)}$ = 2.7 V, the resistance $Rc_1$ = 21.63 Ohms, thus giving a current $I$ = 0.12483 Amps, or 124.83 mA. The measured value is 133.63 mA, providing an error of less than 10%.

Finally, after estimating the current consumption of each compatible camera in high power mode (camera unit 220 powered on and drawing current), the total current consumption can be calculated by including the current consumption of one or more non-compatible cameras:

$$CCt = CC1 + CC2 + CC3 + CC4 + CC5...$$

wherein CCt is the total current consumption, CCi is the current consumption of each camera in high power mode or unknown mode, in the case of the non-compatible camera. The total current consumption may then be compared with a maximum current threshold or power limitation of the power supply source.

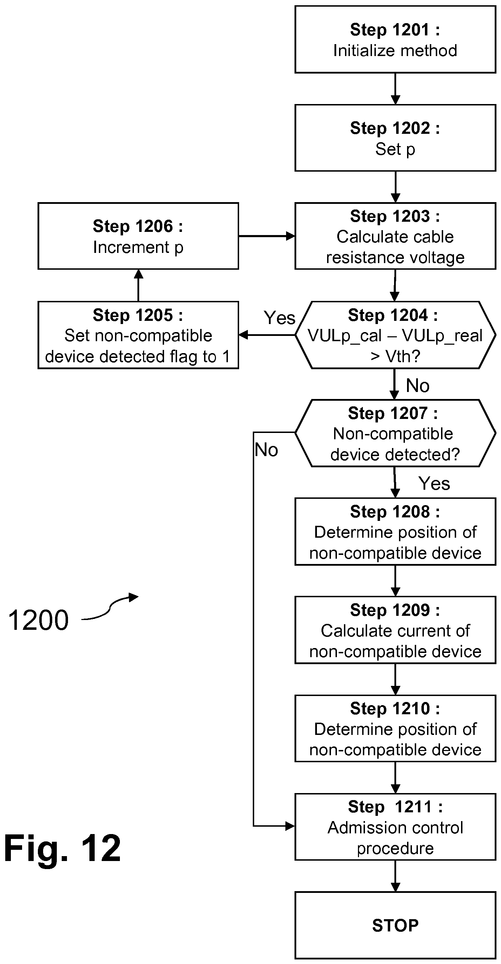

**Figure 12** is a method 1200 of determining whether non-compatible devices are present according to one embodiment, comprising the steps 1201 to 1211, such as performed by a compatible device, either in a master device more or a distributed device mode, or by an entity exterior to the power segment, such as the PSE.

In step 1201, the method is initialized, and the electrical structure of the power segment is known with respect to the compatible cameras CC. The list of compatible cameras, the voltage matrix $M_{LL\_VL}$, the cable segments resistance values $Rc_k$ and positions, and the power profile of each compatible camera are recorded. The compatible cameras CC are set in a low power mode.

In step 1202, an index p, relating to the index of the cameras, is initialized to 0.

In step 1203, a voltage value across the first cable resistance $Rc_1$ is calculated. For example, for p set equal to 0:

$$V_{ULp\_cal} = Rc_1 * (I_{UL(1)} + I_{UL(2)} + I_{UL(3)} + I_{UL(4)}) + V_{UL(1)}$$

wherein $I_{UL}$ is the unloaded current of a compatible camera, such that the sum $I_{UL(1)} + I_{UL(2)} + I_{UL(3)} + I_{UL(4)}$ is the current of all compatible cameras obtained by $(P/V_{UL})$ (in the case of four compatible cameras, such as shown in **Figure 10**), and wherein $V_{UL(1)}$ is the measured unloaded voltage across the first compatible camera.

In step 1204, it is determined whether the difference between the calculated voltage value $V_{ULp\_cal}$ and the measured or recorded voltage value $V_{ULp\_real}$ is greater than or equal to a threshold voltage value $Vth$. For example, the recorded voltage value $V_{ULp\_real}$ may be 56 V as described above, which is stored in a memory of the camera as an initial parameter.

If the response to the determination at step 1204 is Yes (the difference between the values being greater than or equal to the threshold), it signifies that a non-compatible camera NC is detected, and the method proceeds to step 1205.

In step 1205, a non-compatible camera NC detected flag is set to 1, and then in step 1206, the index p is incremented by 1, and the method returns to step 1203.

For a second loop (p = 1), the new computed voltage is:

$$V_{UL1\_cal} = Rc_2 * (I_{UL(2)} + I_{UL(3)} + I_{UL(4)}) + V_{UL(2)}$$

wherein the sum of $I_{UL(2)} + I_{UL(3)} + I_{UL(4)}$ is the current of the compatible cameras obtained by $(P/V_{UL})$, and the value $V_{UL(2)}$ is the measured voltage across the second compatible camera in unloaded mode. In step 1204, another determination is performed between the calculated value and the real value (which may be a measured value of the voltage matrix stored in a memory of the camera), and then the method proceeds either to step 1205 or 1207.

In the case where the response at step 1204 is No (the difference between the values being less than the threshold), in step 1207, it is determined whether a non-compatible camera NC was detected, by reading the flag (set or not in step 1205). If the response is Yes (non-compatible camera detected), the method proceeds to step 1208. Otherwise, if the response is No (no non-compatible camera is detected), then the method proceeds to step 1211, entering an admission control phase to allow or prevent all or some (based on a selection not described here) the compatible cameras from starting in high power mode.

In the case where the response at step 1207 is Yes, in step 1208, the position of the non-compatible camera is determined to be close to the compatible camera with the given index. For example, here close the first compatible camera since the index is set to 1.

In step 1209, the current consumption of the non-compatible camera is estimated by the following equation:

$$Incc\_est = (V_{ULp\_real} - V_{ULp\_cal})/Rc_i$$

wherein Incc_est is the estimated current of the non-compatible camera, $V_{ULp\_real}$ is the measured unloaded voltage of the compatible camera p, $V_{ULp\_cal}$ is the calculated unloaded voltage of the compatible camera p, and $Rc_i$ is the resistance of cable segment $i$.

In step 1210, the total current or the total power consumption of the system is calculated, which will not be described here.

In step 1211, the admission control procedure is performed, and the method stops.

The methods 400, 700, 800, 900 described in relation with **Figures 4, 7, 8, 9** respectively may be implemented by compatible devices belonging to a power segment comprising non-compatible devices.

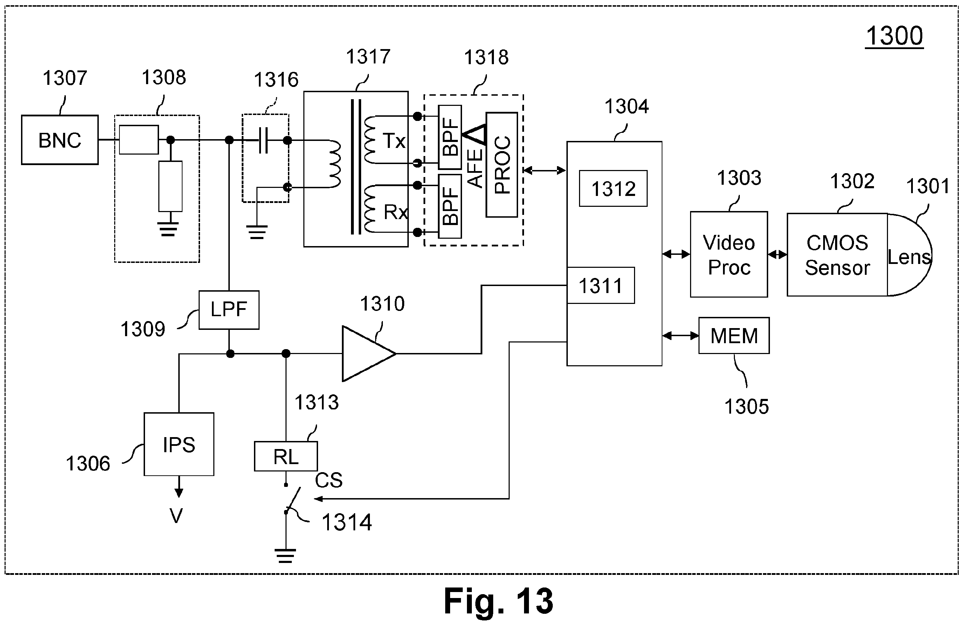

**Figure 13** is a functional block diagram of an integrated device 1300, and more particularly a camera, configured to implement embodiments of the invention. The camera conventionally comprises a lens 1301, a CMOS (Complementary Metal-Oxide-Semiconductor) sensor 1302, a video processor 1303, a network processor 1304, a memory 1305, an internal power supply 1306, and a BNC connector 1307 coupled to a coaxial cable (not shown) transporting power and data. A protection circuit 1308 is coupled to the connector 1307 to protect the camera from an electrical surge. The data and power arriving from the cable are then supplied to two paths, a first path to the internal power supply 1306, and a second path to the network processor 1304.

A low pass filter LPF 1309 is arranged on the first path between the protection circuit 1308 and the internal power supply 1306. The filter 1309 filters the data input from the cable, recovering DC power for the internal power supply 1306, which provides power for the various components of the camera. An amplifier 1310 is coupled to the first path, and receives on input the voltage appearing on the first path, and supplies on output an amplified voltage to an Analog Digital Converter or ADC 1311 arranged within the network processor 1304, which further comprises a power management module 1312.

Similar to **Figures 2B**, a load resistance $R_L$ 1313 and a switch 1314 are arranged so that when the switch 1314 is closed by a control signal CS from the network processor 1304, load adaptation may be performed. The input voltage of the device 1300 is amplified by the amplifier 1310 coupled to the DC power line on output of the lowpass filter 1309, and supplied to the converter 1311. The power management module 1512 of the network processor 1504 provides power control.

A DC isolation circuit 1316, a transformer 1317, and a HPAV module 1318 are arranged on the second path between the protection circuit 1308 and the network processor 1304. The transformer 1317 transforms received signals Rx from the cable to the network processor 1304 and transmitted signals Tx from the network processor 1304 to the cable. The HPAV module 1318 comprises bandpass filters BPF for the transmitted and received data, an Analog Front End AFE circuit and a processor PROC to communicate data packets to and from the network processor 1304. The voltage table (Table 1), the Cable Resistance table (Table 2), and the Computed Voltage table (Table 3) may be stored in the memory 1305 (for example a permanent flash memory or a RAM memory).

The device 1300 may be in low power consumption (less than 2 Watts) during a sequence of load adaptation or while detecting any non-compatible devices, as described, and in a normal power operating mode (around 10 Watts) otherwise. During the low power mode, only the necessary components are powered, such as the network processor 1304 including the converter 1311, the memory 1305, the internal power supply 1306, and the HPAV module 1318. Other components, such as the CMOS sensor 1302, the video processor 1303, and other components non-essential for the detection of non-compatible devices may be in stand-by mode or switched-off.

The device 1300 is thus an integrated device, wherein all components are comprised in a single housing. The device 1300 has the advantages of lower cost and easier maintainability, as well as all algorithms being run on a single processor 1304.

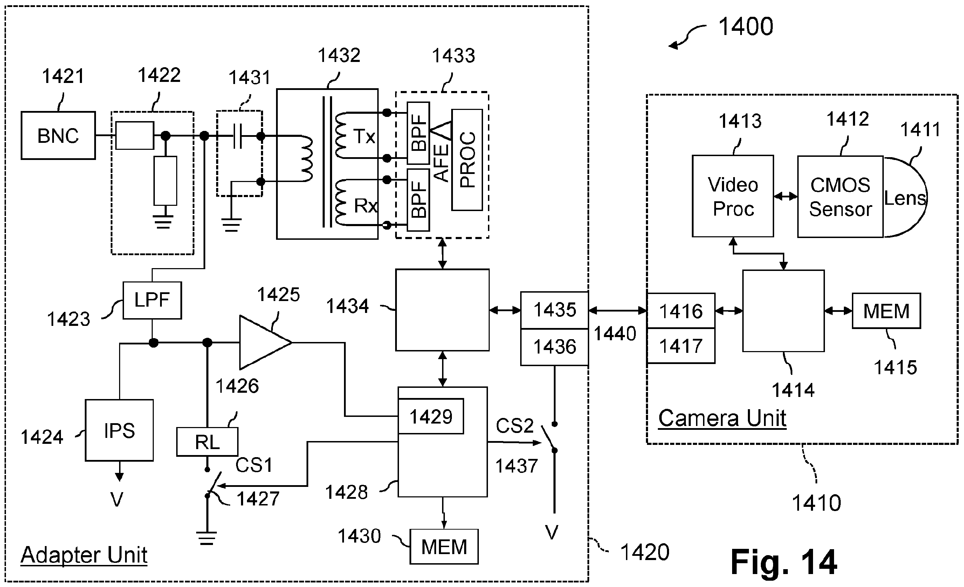

**Figure 14** is a functional block diagram of a modular device 1400, and more particularly a camera, configured to implement embodiments of the invention. The camera 1400 comprises a camera unit 1410 and an adapter unit 1420. The camera unit 1410 comprises a lens 1411, a CMOS sensor 1412, a video processor 1413, a network processor 1414, at least one memory 1415, and an Ethernet transceiver 1416 coupled to a power device circuit 1417 (a power device according to the Power over Ethernet Standard).

The adapter unit 1420 comprises, similarly to **Figure 13**, a BNC Connector 1421, a protection circuit 1422, a low-pass filter 1423, an internal power supply 1424, an amplifier 1425, a resistor 1426, a switch 1427, a microcontroller 1428 comprising an analog to digital converter 1429, a memory 1430, a DC isolation circuit 1431, a transformer 1432, and an HPAV module 1433.

The adapter unit 1420 further comprises a three port Ethernet bridge 1434 coupled to a physical interface PI 1435 (such as an Ethernet transceiver), a power supply circuit 1436 (Power Supply Equipment according to the Power over Ethernet standard), and a second switch 1437 controlled by a control signal CS2 from the microcontroller 1428. A cable 1440, such as an Ethernet cable or other connection, couples the physical interfaces 1416, 1435.

The camera unit 1410 can be not powered during the various methods described in the preceding, only the adapter unit 1420 being powered, in particular the internal power supply 1424, the microcontroller 1428, the memory 1430, and the HPAV module 1433. The microcontroller 1428 may control the power to the camera unit 1410 by means of the switch 1437, which supplies a voltage V to the camera via the PoE-PSE circuit 1436. At the end of the methods according to the invention, if the power and the voltage on the power segment are sufficient for each compatible device, then the microcontroller 1428 enables the PoE PSE circuit 1436 to power-on the camera unit 1410. After that, the camera unit 1410 can transmit the video stream through the Ethernet link 1416-1435, and it can be controlled by the user. Functions performed by the Network processor 1304 of **Figure 13** may be performed by the microcontroller 1428, and the Tables 1, 2, 3 may be stored in the memory 1430.

The camera 1400 is thus a modular device, wherein the actual camera 1410 has an external adapter unit 1420. The camera 1400 has the advantages of being able to adapt a conventional existing camera (comprising only the elements of camera unit 1410) by simply adding the adapter unit 1420, saving cost. All algorithms are run on the processor 1428.

In a variation of the device 1400 shown in **Figure 14**, the algorithms are run on the network processor 1414 of the camera unit 1410 as the master CPU. The processor 1428 of the adapter unit 1420 is a slave CPU, executing commands sent by the master CPU 1414 via the Ethernet link 1440.

The messages exchanged via the link 1440 may be control of the switch 1427 and measurement data from the slave CPU 1428 to the master CPU 1414. These messages may be internal synchronization messages and not necessarily sent using the HomePlug AV messaging system, but may be sent by using Ethernet level 2 protocols.

The link 1440 may preferably be an Ethernet level 2 protocol link, but alternatively may be of any other communication type: classical bus, USB type, etc.

Additionally, the adapter unit 1420 and the camera unit 1410 are here considered as paired, therefore the source address and the destination address (i.e. the MAC address of the adapter and of the camera) are known by each, allowing local message exchange between them, without having to send messages over the network.

It will be noted that though it has been described that the unloaded electrical measurements are performed first and the loaded electrical measurements are performed second, the loaded electrical measurements may instead be performed first, the unloaded electrical measurements being performed second, or alternating as needed. Furthermore, it is preferred that the unloaded and loaded measurements be performed in close succession, to ensure that the system configuration has not changed in between (for example the addition of a camera), and that the system parameters (temperature, voltage supply, etc.) have not changed.

Additionally, not all cameras (or all compatible cameras) have to be equipped with both the load resistance $R_L$ 251 and the switch 252. In this case, the camera merely comprises means for measuring the unloaded voltage $V_{UL}$ and the remote loaded voltage $V_{RL}$. This method may provide less-precise results, but may reduce the cost of the camera and simplify the method.

Finally, though the preceding method and system has been described with cables carrying both power and data, it is to be understand that a cable may carry only one, the other being provided by other means. For example, the cameras could be powered by their own plugs and/or batteries, the cables only providing data communication between the cameras. Likewise, the cameras could be powered by the cables, with other communication means (such as over the air) being used for data communication.

Although the present invention has been described hereinabove with reference to specific embodiments, the present invention is not limited to the specific embodiments, and modifications which lie within the scope of the present invention will be apparent to a person skilled in the art. Many further modifications and variations will suggest themselves to those versed in the art upon making reference to the foregoing illustrative embodiments, which are given by way of example only and which are not intended to limit the scope of the invention as determined by the appended claims. In particular different features from different embodiments may be interchanged, where appropriate.

## Claims

1. A method for enabling the determining of resistances of cable segments of a power segment, the power segment comprising at least two devices coupled to a power source by means of the cable segments, wherein each device comprises:

   - a switch arranged in series with a load, the switch being configured to open and close upon receipt of a command signal, wherein when the switch is open, the load is decoupled and the device is unloaded, and when the switch is closed, the load is coupled and the device is loaded, and
   - communication means for communicating data to the other at least one device,the method comprising the following steps performed by at least one device:
   - measuring a first voltage during a first time period to obtain a first voltage result, wherein during the first time period all loads of all devices of the power segment are uncoupled so as to obtain unloaded electrical measurements for all devices of the power segment;
   - measuring a second voltage during a second time period to obtain a second voltage result, wherein during the second time period load adaptation is performed by:

     coupling the load of at least one device of the power segment so as to obtain a local loaded electrical measurement for the device having the coupled load, and
     uncoupling the load of at least the one other device of the power segment so as to obtain a remote loaded electrical measurement for the device having the uncoupled load; and

   - communicating the first voltage result and the second voltage result to a processing unit using the communication means, thereby for the processing unit to compute the resistances of the cable segments to which the devices are coupled.

2. The method according to claim 1, further comprising the steps, for a device, of:

   - receiving an initialize sensing message indicating the start of a time period,
   - receiving a start sensing message launching the time period,
   - sending a sensing results message comprising the measurement result,

- receiving a stop sensing message indicating the end of the time period,
- receiving a load change message indicating that a device should perform load adaptation,
- receiving a sensing finished message, ending the sensing method.

3.  The method according to claim 2, further comprising a step of determining one device of the power segment to be a master device, the other at least one device of the power segment being a slave device, and wherein the master device is configured to :

    - send the initialize sensing message, the start sensing message, the stop sensing message, the load change message, and the sensing finished message; and
    - receive the sensing results message or messages.

4.  The method according to claim 3, further comprising the steps, performed by a slave device, of:

    - waiting to receive a message sent by the master device,
    - determining the type of the message, and:

        - if the message is a start sensing message, then performing the first electrical measurement, sending the first measurement results, and receiving the stop sensing message,
        - if the message is a sensing finished message, then stopping the sensing method,
        - if the message is a load change message, then determining whether it has been selected to perform load adaptation.

5.  The method according to claim 4, wherein if the slave device has been selected to perform load adaptation, then the slave device performs the steps of:

    - receiving the start sensing message,
    - performing the local loaded electrical measurement,
    - sending the local loaded electrical measurement result, and
    - receiving the stop sensing message,
    otherwise, if the slave device has not been selected to perform load adaptation, then the slave device performs the steps of:

        - receiving the start sensing message,
        - performing the remote loaded electrical measurement,
        - sending the remote loaded electrical measurement result, and
        - receiving the stop sensing message.

6.  The method according to claim 5, further comprising a step of, after receiving the stop sensing message, the slave device returns to the step of waiting for a message.

7.  The method according to claim 2, further comprising the steps of:

    - choosing, by the devices of the power segment, a device to send the initialize sensing message,
    - sending, by the chosen device, the initialize sensing message,
    - receiving, by the non-chosen device or devices, the initialize sensing message, and
    - sending, by the chosen device, the start sensing message.

8.  The method according to claim 7, further comprising the steps of:

    - selecting, by the devices of the power segment, at least one device to perform load adaptation,
    - determining, by each device of the power segment, whether it has been selected to perform load adaptation, and
    - if the response is yes, then:

        - sending the load change message to at least one other device,
        - sending the start sensing message to at least one other device,
        - performing the local loaded electrical measurement, and
        - sending the stop sensing message to at least one other device,

- if the response is no, then:

- receiving the load change message from the selected device,
- receiving the start sensing message from the selected device,
- performing the remote loaded electrical measurement,
- sending the remote loaded measurement result to at least one other device, and
- receiving the stop sensing message from the selected device.

9. The method according to one of claims 1 to 8, further comprising a step of selecting another device of the power segment to perform load adaptation.

10. The method according to one of claims 1 to 9, further comprising a step of determining the order of the devices of the power segment by using the measurement results.

11. The method according to one of claims 1 to 10, further comprising the step of using the computed cable segment resistance to detect the presence of a non-compatible device.

12. The method according to claim 11, further comprising the steps of:

- obtaining a list of compatible devices, measurement results, and the power profile of each compatible device,
- setting the compatible devices in a low power mode,
- calculating, for each cable segment, a voltage value across the cable,
- determining whether the difference between the calculated voltage value and a measured voltage value is greater than or equal to a threshold voltage value,
- if the response is yes, then determining that a non-compatible device is detected, otherwise
- if the response is no, then determining that a non-compatible device is not detected.

13. The method according to step 12, further comprising, if a non-compatible device was selected, the steps of:

- estimating the current consumption of the non-compatible device,
- calculating the total current or the total power consumption of the system, and
- performing an admission control procedure to determine whether a compatible device can start in high power mode.

14. A load adaptation device for enabling the determining of resistances of cable segments of a power segment, the power segment comprising at least two devices coupled to a power source by means of the cable segments, wherein each device comprises:

- communication means for communicating data to the other at least one device,
- a sensing unit arranged on input to the device, the sensing unit comprising a switch arranged in series with a load, the switch being configured to open and close upon receipt of a command signal, wherein when the switch is open, the load is decoupled and the device is unloaded, and when the switch is closed, the load is coupled and the device is loaded,
- means for measuring a first voltage during a first time period to obtain a first voltage result, wherein during the first time all loads of all devices of the power segment are uncoupled so as to obtain unloaded electrical measurements for all devices of the power segment;
- means for measuring a second voltage during a second time period to obtain a second voltage result, wherein during the second time period load adaptation is performed by:

coupling the load of at least one device of the power segment so as to obtain a local loaded electrical measurement for the device having the coupled load, and
uncoupling the load of at least the one other device of the power segment so as to obtain a remote loaded electrical measurement for the device having the uncoupled load; and

- means for communicating the first voltage result and the second voltage result to a processing unit using the communication means, thereby for the processing unit to compute the resistances of the cable segments to which the devices are coupled.

**15.** The device according to claim 14, wherein the sensing unit further comprises an analog to digital converter configured to measure a voltage value across the switch and the load, and to send the measured value to a processor.

**16.** The device according to claim 15, wherein the sensing unit further comprises a current measurement unit comprising a resistor and a differential amplifier, the differential amplifier measuring the voltage across the resistor to measure an input current of the device.

**17.** The device according to one of claims 14 to 16, wherein the device comprising an adapter unit comprising the sensing unit and a functional unit configured to perform the core device functions.

**Patentansprüche**

**1.** Verfahren zum Ermöglichen der Bestimmung von Widerständen von Kabelsegmenten eines Energiesegments, wobei das Energiesegment mindestens zwei Geräte umfasst, die über die Kabelsegmente mit einer Energiequelle gekoppelt sind,
wobei jedes Gerät umfasst:

- einen Schalter, der in Reihe mit einer Last angeordnet ist, wobei der Schalter dazu eingerichtet ist, um bei einem Empfangen eines Befehlssignals zu öffnen und zu schließen, wobei, wenn der Schalter geöffnet ist, die Last entkoppelt ist und das Gerät unbelastet ist, und wenn der Schalter geschlossen ist, die Last gekoppelt ist und das Gerät belastet ist, und
- ein Kommunikationsmittel zum Kommunizieren von Daten zu dem anderen mindestens einem Gerät, wobei das Verfahren die folgenden Schritte umfasst, die von mindestens einem Gerät ausgeführt werden:

- Messen einer ersten Spannung während eines ersten Zeitraums, um ein erstes Spannungsergebnis zu erhalten, wobei während des ersten Zeitraums alle Lasten von allen Geräten des Energiesegments entkoppelt sind, um unbelastete elektrische Messungen für alle Geräte des Energiesegments zu erhalten;
- Messen einer zweiten Spannung während eines zweiten Zeitraums, um ein zweites Spannungsergebnis zu erhalten, wobei während des zweiten Zeitraums eine Lastanpassung durchgeführt wird, durch:

- Koppeln der Last von mindestens einem Gerät des Energiesegments, um eine lokalbelastete elektrische Messung für das Gerät zu erhalten, das die gekoppelte Last aufweist, und
- Entkoppeln der Last von mindestens dem einen anderen Gerät des Energiesegments, um eine fernbelastete elektrische Messung für das Gerät zu erhalten, das die entkoppelte Last aufweist; und

- Kommunizieren des ersten Spannungsergebnisses und des zweiten Spannungsergebnisses an eine Verarbeitungseinheit, unter Verwendung des Kommunikationsmittels, dadurch für die Verarbeitungseinheit zur Berechnung der Widerstände der Kabelsegmente, an die die Geräte gekoppelt sind.

**2.** Verfahren nach Anspruch 1, ferner mit den Schritten, für ein Gerät:

- Empfangen einer Initialisierungserkennungsnachricht, die den Beginn erstes Zeitraums angibt;
- Empfangen einer Starterkennungsnachricht, die den Zeitraum startet;
- Senden einer Erkennungsergebnisnachricht, die das Messergebnis umfasst,
- Empfangen einer Stopperkennungsnachricht, die das Ende des Zeitraums anzeigt,
- Empfangen einer Laständerungsnachricht, die angibt, dass ein Gerät eine Lastanpassung durchführen soll,
- Empfangen einer Erkennungsbeendigungsnachricht, die das Erkennungsverfahren beendet.

**3.** Verfahren nach Anspruch 2, ferner mit einem Schritt eines Bestimmens eines Geräts des Energiesegments als ein Master-Gerät, wobei das andere mindestens eine Gerät des Energiesegments ein Slave-Gerät ist und wobei das Master-Gerät dazu eingerichtet ist, um folgendes auszuführen:

- Senden der Initialisierungserkennungsnachricht, der Starterkennungsnachricht, der Stopperkennungsnachricht, der Laständerungsnachricht, und der Erkennungsbeendigungsnachricht; und
- Empfangen der Erkennungsergebnisnachricht oder der Erkennungsergebnisnachrichten.

**4.** Verfahren nach Anspruch 3, ferner mit den Schritten, die von einem Slave-Gerät durchgeführt werden:

- Warten, um eine von dem Master-Gerät gesendete Nachricht zu empfangen,
- Bestimmen der Art der Nachricht, und:

falls es sich bei der Nachricht um eine Starterkennungsnachricht handelt, die erste elektrische Messung durchführen, die ersten Messergebnisse senden, und die Stopperkennungsnachricht empfangen,

falls es sich bei der Nachricht um eine Erkennungsbeendigungsnachricht handelt, das Erkennungsverfahren beenden,

falls es sich bei der Nachricht um eine Laständerungsnachricht handelt, zu bestimmen, ob sie ausgewählt wurde, um eine Lastanpassung durchzuführen.

5. Verfahren nach Anspruch 4, wobei, falls das Slave-Gerät ausgewählt wurde, um eine Lastanpassung durchzuführen, das Slave-Gerät dann die folgenden Schritte durchführt:

- Empfangen der Starterkennungsnachricht,
- Durchführen der lokalbelasteten elektrischen Messung,
- Senden des lokalbelasteten elektrischen Messergebnisses, und
- Empfangen der Stopperkennungsnachricht,

andernfalls, falls das Slave-Gerät nicht ausgewählt wurde, um eine Lastanpassung durchzuführen, führt das Slave-Gerät dann die folgenden Schritte durch:

- Empfangen der Starterkennungsnachricht,
- Durchführen der fernbelasteten elektrischen Messung,
- Senden des fernbelasteten elektrischen Messergebnisses, und
- Empfangen der Stopperkennungsnachricht.

6. Verfahren nach Anspruch 5, ferner mit einem Schritt, nach einem Empfangen der Stopperkennungsnachricht, in dem das Slave-Gerät zu dem Schritt des Wartens auf eine Nachricht zurückkehrt.

7. Verfahren nach Anspruch 2, ferner mit den Schritten:

- Auswählen, durch die Geräte des Energiesegments, eines Geräts, um die Initialisierungserkennungsnachricht zu senden;
- Senden, durch das ausgewählte Gerät, der Initialisierungserkennungsnachricht,
- Empfangen, durch das nicht ausgewählte Gerät oder die nicht ausgewählten Geräte, der Initialisierungserkennungsnachricht, und
- Senden, durch das ausgewählte Gerät, der Starterkennungsnachricht.

8. Verfahren nach Anspruch 7, ferner mit den Schritten:

- Auswählen, durch die Geräte des Energiesegments, von mindestens einem Gerät, um eine Lastanpassung durchzuführen;
- Bestimmen, durch jedes Gerät des Energiesegments, ob es ausgewählt wurde, um eine Lastanpassung durchzuführen, und

falls die Antwort ja ist, dann:

- Senden der Laständerungsnachricht an mindestens ein anderes Gerät,
- Senden der Starterkennungsnachricht an mindestens ein anderes Gerät,
- Durchführen der lokalbelasteten elektrischen Messung, und
- Senden der Stopperkennungsnachricht an mindestens ein anderes Gerät,

- falls die Antwort nein ist, dann:

- Empfangen der Laständerungsnachricht von dem ausgewählten Gerät,
- Empfangen der Starterkennungsnachricht von dem ausgewählten Gerät,
- Durchführen der fernbelasteten elektrischen Messung,
- Senden des fernbelasteten Spannungsergebnisses an mindestens ein anderes Gerät, und
- Empfangen der Stopperkennungsnachricht von dem ausgewählten Gerät.

9. Verfahren nach einem der Ansprüche 1 bis 8, ferner mit einem Schritt eines Auswählens eines anderen Geräts des Energiesegments, um eine Lastanpassung durchzuführen.

10. Verfahren nach einem der Ansprüche 1 bis 9, ferner mit einem Schritt eines Bestimmens der Reihenfolge der Geräte des Energiesegments unter Verwendung der Messergebnisse.

11. Verfahren nach einem der Ansprüche 1 bis 10, ferner mit dem Schritt eines Verwendens des berechneten Kabelsegmentwiderstands, um das Vorhandensein eines nicht kompatiblen Geräts zu erfassen.

12. Verfahren nach Anspruch 11, ferner mit den Schritten:

   - Erhalten einer Liste kompatibler Geräte, von Messergebnissen, und des Leistungsprofils jedes kompatiblen Geräts;
   - Einstellen der kompatiblen Geräte in einem Niedrigenergiemodus,
   - Berechnen, für jedes Kabelsegment, eines Spannungswerts über dem Kabel,
   - Bestimmen, ob die Differenz zwischen dem berechneten Spannungswert und einem gemessenen Spannungswert größer oder gleich einem Grenzspannungswert ist,
   - falls die Antwort ja ist, dann bestimmen, dass ein nicht kompatibles Gerät erfasst ist, andererseits
   - falls die Antwort nein ist, dann bestimmen, dass ein nicht kompatibles Gerät nicht erfasst ist.

13. Verfahren nach Schritt 12, ferner mit den Schritten, falls ein nicht kompatibles Gerät ausgewählt wurde:

   - Schätzen des Stromverbrauchs des nicht kompatiblen Geräts,
   - Berechnen des Gesamtstroms oder des Gesamtenergieverbrauchs des Systems, und
   - Durchführen eines Zulassungssteuerungsverfahrens, um zu bestimmen, ob ein kompatibles Gerät in einem Hochenergiemodus starten kann.

14. Lastanpassungsgerät zum Ermöglichen der Bestimmung von Widerständen von Kabelsegmenten eines Energiesegments, wobei das Energiesegment mindestens zwei Geräte umfasst, die über die Kabelsegmente mit einer Energiequelle gekoppelt sind,
   wobei jedes Gerät umfasst:

   - ein Kommunikationsmittel zum Kommunizieren von Daten zu dem anderen mindestens einem Gerät,
   - einer Erkennungseinheit, die an einem Eingang des Geräts angeordnet ist, wobei die Erkennungseinheit einen Schalter umfasst, der in Reihe mit der Last angeordnet ist, wobei der Schalter dazu eingerichtet ist, um bei einem Empfangen eines Befehlssignals zu öffnen und zu schließen, wobei, wenn der Schalter geöffnet ist, die Last entkoppelt ist und das Gerät unbelastet ist, und wenn der Schalter geschlossen ist, die Last gekoppelt ist und das Gerät belastet ist,
   - ein Mittel zur Messung einer ersten Spannung während eines ersten Zeitraums, um ein erstes Spannungsergebnis zu erhalten, wobei während des ersten Zeitraums alle Lasten von allen Geräten des Energiesegments entkoppelt sind, um unbelastete elektrische Messungen für alle Geräte des Energiesegments zu erhalten;
   - ein Mittel zur Messung einer zweiten Spannung während eines zweiten Zeitraums, um ein zweites Spannungsergebnis zu erhalten, wobei während des zweiten Zeitraums eine Lastanpassung durchgeführt wird, durch:

      - Koppeln der Last von mindestens einem Gerät des Energiesegments, um eine lokalbelastete elektrische Messung für das Gerät zu erhalten, das die gekoppelte Last aufweist, und
      - Entkoppeln der Last von mindestens dem einen anderen Gerät des Energiesegments, um eine fernbelastete elektrische Messung für das Gerät zu erhalten, das die entkoppelte Last aufweist; und

      - ein Mittel zum Kommunizieren des ersten Spannungsergebnisses und des zweiten Spannungsergebnisses an eine Verarbeitungseinheit, unter Verwendung des Kommunikationsmittels, dadurch für die Verarbeitungseinheit zur Berechnung der Widerstände der Kabelsegmente, an die die Geräte gekoppelt sind.

15. Vorrichtung nach Anspruch 14, wobei die Erkennungseinheit ferner einen Analog-Digital-Wandler umfasst, der dazu eingerichtet ist, um einen Spannungswert über dem Schalter und der Last zu messen, und den gemessenen Wert an einen Prozessor zu senden.

16. Vorrichtung nach Anspruch 15, wobei die Erkennungseinheit ferner eine Strommesseinheit umfasst, die einen Widerstand und einen Differenzverstärker umfasst, wobei der Differenzverstärker die Spannung über dem Widerstand misst, um einen Eingangsstrom des Geräts zu messen.

17. Vorrichtung nach einem der Ansprüche 14 bis 16, wobei das Gerät eine Adaptereinheit, die die Erkennungseinheit umfasst, und eine Funktionseinheit, die dazu eingerichtet ist, um die Kerngerätfunktionen auszuführen, umfasst.

## Revendications

1. Procédé pour permettre la détermination de résistances de segments de câble d'un segment de puissance, le segment de puissance comprenant au moins deux dispositifs couplés à une source de puissance au moyen des segments de câble,
dans lequel chaque dispositif comprend :

   - un commutateur disposé en série avec une charge, le commutateur étant configuré pour ouvrir et fermer à réception d'un signal de commande, dans lequel lorsque le commutateur est ouvert, la charge est découplée et le dispositif est non chargé, et lorsque le commutateur est fermé, la charge est couplée et le dispositif est chargé, et
   - des moyens de communication pour communiquer des données à l'autre au moins un dispositif, le procédé comprenant les étapes suivantes réalisées par au moins un dispositif :

      - mesurer une première tension pendant une première période de temps pour obtenir un résultat de première tension, dans lequel pendant la première période de temps toutes les charges de tous les dispositifs du segment de puissance sont non couplées de manière à obtenir des mesures électriques non chargées pour tous les dispositifs du segment de puissance ;
      - mesurer une seconde tension pendant une seconde période de temps pour obtenir un résultat de seconde tension, dans lequel pendant la seconde période de temps une adaptation de charge est réalisée en :

         couplant la charge d'au moins un dispositif du segment de puissance de manière à obtenir une mesure électrique chargée locale pour le dispositif présentant la charge couplée, et
         découplant la charge d'au moins le un autre dispositif du segment de puissance de manière à obtenir une mesure électrique chargée distante pour le dispositif présentant la charge non couplée ; et

      - communiquer le résultat de première tension et le résultat de seconde tension à une unité de traitement à l'aide des moyens de communication, ce faisant pour que l'unité de traitement calcule les résistances des segments de câble auxquels les dispositifs sont couplés.

2. Procédé selon la revendication 1, comprenant en outre les étapes, pour un dispositif, consistant à :

   - recevoir un message de détection d'initialisation indiquant le début d'une période de temps,
   - recevoir un message de détection de début lançant la période de temps,
   - envoyer un message de résultats de détection comprenant le résultat de mesure,
   - recevoir un message de détection d'arrêt indiquant le terme de la période de temps,
   - recevoir un message de modification de charge indiquant qu'un dispositif devrait réaliser une adaptation de charge,
   - recevoir un message de fin de détection, terminant le procédé de détection.

3. Procédé selon la revendication 2, comprenant en outre une étape de détermination d'un dispositif du segment de puissance pour servir de dispositif maître, l'autre au moins un dispositif du segment de puissance étant un dispositif esclave, et dans lequel le dispositif maître est configuré pour :

   - envoyer le message de détection d'initialisation, le message de détection de début, le message de détection d'arrêt, le message de modification de charge et le message de fin de détection ; et
   - recevoir le message ou les messages de résultats de détection.

4. Procédé selon la revendication 3, comprenant en outre les étapes, réalisées par un dispositif esclave, consistant à :

   - attendre de recevoir un message envoyé par le dispositif maître,

- déterminer le type du message, et :

- si le message est un message de détection de début, réaliser alors la première mesure électrique, envoyer les résultats de première mesure, et recevoir le message de détection d'arrêt,
- si le message est un message de fin de détection, arrêter alors le procédé de détection.
- si le message est un message de modification de charge, déterminer alors s'il a été sélectionné pour réaliser une adaptation de charge.

5. Procédé selon la revendication 4, dans lequel si le dispositif esclave a été sélectionné pour réaliser une adaptation de charge, le dispositif esclave réalise alors les étapes consistant à :

- recevoir le message de détection de début,
- réaliser la mesure électrique chargée locale,
- envoyer le résultat de mesure électrique chargée locale, et
- recevoir le message de détection d'arrêt,
sinon, si le dispositif esclave n'a pas été sélectionné pour réaliser une adaptation de charge, le dispositif esclave réalise alors les étapes consistant à :

- recevoir le message de détection de début,
- réaliser la mesure électrique chargée distante,
- envoyer le résultat de mesure électrique chargée distante, et
- recevoir le message de détection d'arrêt.

6. Procédé selon la revendication 5, comprenant en outre une étape où, après réception du message de détection d'arrêt, le dispositif esclave retourne à l'étape consistant à attendre un message.

7. Procédé selon la revendication 2, comprenant en outre les étapes consistant à :

- choisir, par les dispositifs du segment de puissance, un dispositif pour envoyer le message de détection d'initialisation,
- envoyer, par le dispositif choisi, le message de détection d'initialisation,
- recevoir, par le dispositif ou les dispositifs non choisi(s), le message de détection d'initialisation, et
- envoyer, par le dispositif choisi, le message de détection de début.

8. Procédé selon la revendication 7, comprenant en outre les étapes consistant à :

- sélectionner, par les dispositifs du segment de puissance, au moins un dispositif pour réaliser une adaptation de charge,
- déterminer, par chaque dispositif du segment de puissance, s'il a été sélectionné pour réaliser une adaptation de charge, et
- si la réponse est oui, alors :

- envoyer le message de modification de charge à au moins un autre dispositif,
- envoyer le message de détection de début à au moins un autre dispositif,
- réaliser la mesure électrique chargée locale, et
- envoyer le message de détection d'arrêt à au moins un autre dispositif,

- si la réponse est non, alors :

- recevoir le message de modification de charge depuis le dispositif sélectionné,
- recevoir le message de détection de début depuis le dispositif sélectionné,
- réaliser la mesure électrique chargée distante,
- envoyer le résultat de mesure chargée distante à au moins un autre dispositif, et
- recevoir le message de détection d'arrêt depuis le dispositif sélectionné.

9. Procédé selon l'une des revendications 1 à 8, comprenant en outre une étape consistant à sélectionner un autre dispositif du segment de puissance pour réaliser une adaptation de charge.

10. Procédé selon l'une des revendications 1 à 9, comprenant en outre une étape consistant à déterminer l'ordre des dispositifs du segment de puissance à l'aide des résultats de mesure.

11. Procédé selon l'une des revendications 1 à 10, comprenant en outre l'étape consistant à utiliser la résistance de segment de câble calculée pour détecter la présence d'un dispositif non compatible.

12. Procédé selon la revendication 11, comprenant en outre les étapes consistant à :

- obtenir une liste de dispositifs compatibles, des résultats de mesure et le profil de puissance de chaque dispositif compatible,
- régler les dispositifs compatibles dans un mode basse puissance,
- calculer, pour chaque segment de câble, une valeur de tension à travers le câble,
- déterminer si la différence entre la valeur de tension calculée et une valeur de tension mesurée est supérieure ou égale à une valeur de tension de seuil,
- si la réponse est oui, déterminer alors qu'un dispositif non compatible a été détecté, sinon
- si la réponse est non, déterminer alors qu'un dispositif non compatible n'a pas été détecté.

13. Procédé selon la revendication 12, comprenant en outre, si un dispositif non compatible a été sélectionné, les étapes consistant à :

- estimer la consommation de courant du dispositif non compatible,
- calculer le courant total de la consommation de puissance totale du système, et
- réaliser une procédure de contrôle d'admission pour déterminer si un dispositif compatible peut débuter en mode haute puissance.

14. Dispositif d'adaptation de charge pour permettre la détermination de résistances de segments de câble d'un segment de puissance, le segment de puissance comprenant au moins deux dispositifs couplés à une source de puissance au moyen des segments de câble, dans lequel chaque dispositif comprend :

- des moyens de communication pour communiquer des données à l'autre au moins un dispositif,
- une unité de détection agencée en entrée du dispositif, l'unité de détection comprenant un commutateur disposé en série avec une charge, le commutateur étant configuré pour ouvrir et fermer à réception d'un signal de commande, dans lequel lorsque le commutateur est ouvert, la charge est découplée et le dispositif est non chargé, et lorsque le commutateur est fermé, la charge est couplée et le dispositif est chargé,
- des moyens pour mesurer une première tension pendant une première période de temps pour obtenir un résultat de première tension, dans lequel pendant la première période de temps toutes les charges de tous les dispositifs du segment de puissance sont non couplées de manière à obtenir des mesures électriques non chargées pour tous les dispositifs du segment de puissance ;
- des moyens pour mesurer une seconde tension pendant une seconde période de temps pour obtenir un résultat de seconde tension, dans lequel pendant la seconde période de temps une adaptation de charge est réalisée en :

couplant la charge d'au moins un dispositif du segment de puissance de manière à obtenir une mesure électrique chargée locale pour le dispositif présentant la charge couplée, et
découplant la charge d'au moins le un autre dispositif du segment de puissance de manière à obtenir une mesure électrique chargée distante pour le dispositif présentant la charge non couplée ; et

- des moyens pour communiquer le résultat de première tension et le résultat de seconde tension à une unité de traitement à l'aide des moyens de communication, ce faisant pour que l'unité de traitement calcule les résistances des segments de câble auxquels les dispositifs sont couplés.

15. Dispositif selon la revendication 14, dans lequel l'unité de détection comprend en outre un convertisseur analogique-numérique configuré pour mesurer une valeur de tension à travers le commutateur et la charge, et pour envoyer la valeur mesurée à un processeur.

16. Dispositif selon la revendication 15, dans lequel l'unité de détection comprend en outre une unité de mesure de courant comprenant une résistance et un amplificateur différentiel, l'amplificateur différentiel mesurant la tension à travers la résistance pour mesurer un courant d'entrée du dispositif.

17. Dispositif selon l'une des revendications 14 à 16, dans lequel le dispositif comprenant une unité d'adaptateur comprenant l'unité de détection et une unité fonctionnelle configurée pour réaliser les fonctions essentielles du dispositif.

Fig. 1A

**Fig. 1B**

EP 3 482 530 B1

**Fig. 2A**

EP 3 482 530 B1

**Fig. 2B**

**Fig. 3**

EP 3 482 530 B1

400

```
┌─────────────────────┐
│     Step 401 :      │
│ Determine unloaded  │
│    time periods     │
└─────────────────────┘
           │
           ▼
┌─────────────────────┐
│     Step 402 :      │
│  Determine loaded   │
│    time periods     │
└─────────────────────┘
           │
           ▼
┌─────────────────────┐
│     Step 403 :      │
│  Determine sensing  │
│    time periods     │
└─────────────────────┘
           │
           ▼
┌─────────────────────┐
│     Step 404 :      │
│  Perform electrical │
│    measurements     │
└─────────────────────┘
           │
           ▼
┌─────────────────────┐
│     Step 405 :      │
│ Send/receive        │
│  electrical         │
│  measurements       │
└─────────────────────┘
           │
           ▼
┌─────────────────────┐
│     Step 406 :      │
│   Compute cable     │
│    resistance       │
└─────────────────────┘
           │
           ▼
       ┌────────┐
       │  STOP  │
       └────────┘
```

# Fig. 4

Fig. 5

EP 3 482 530 B1

EP 3 482 530 B1

600

| Field 601: SOURCE_ ID | Field 602: DEST_ ID | Field 603: SEGMENT_ ID | Field 604: PACKET_ SIZE | Field 605: MESSAGE_ TYPE |
|---|---|---|---|---|

610

| Field 611: SOURCE_ ID | Field 612: DEST_ ID | Field 613: SEGMENT_ ID | Field 614: PACKET_ SIZE | Field 615: MESSAGE_ TYPE | Field 616 : LOAD_ CHANGE_NB | Field 617 : LOAD_ CHANGE_ID |
|---|---|---|---|---|---|---|

620

| Field 621 : SOURCE_ ID | Field 622 : DEST_ ID | Field 623 : SEGMENT_ ID | Field 624 : PACKET_ SIZE | Field 625 : MESSAGE_ TYPE | Field 626 : SENSING_ FEEDBACK |
|---|---|---|---|---|---|

# Fig. 6

**Step 701 :**
Device startup

**Step 702 :**
Get device ID list

**Step 703 :**
Send Initialize Sensing
message 501

**Step 704 :**
Send Start Sensing
message 502

**Step 705 :**
Receive Sensing
Results messages 503

**Step 706 :**
Send Stop Sensing
message 504

**Step 707 :**
Select device for
loaded time period

**Step 708 :**
Send Load Change
message 505

**Step 709 :**
Send Start Sensing
message 502'

700

**Step 710 :**
Receive Sensing
Result messages 503'

**Step 711 :**
Send Stop Sensing
message 504'

No

**Step 712 :**
Load adaptation
complete?

Yes

**Step 713 :**
Send Sensing
Finished message 506

**Step 714 :**
Determine device
order

**Step 715 :**
Compute cable
resistances

STOP

# Fig. 7

## Fig. 8

800

**Step 801 :**
Device startup

**Step 802 :**
Receive Initialize
Sensing message 501

**Step 803 :**
Wait for a message

Start Sensing 502

**Step 805 :**
Perform unloaded
voltage measurement

**Step 804 :**
Receive message,
determine type

Sensing
Finished 506

**Step 806 :**
Send Sensing Results
message 503 (VUL)

**Step 807 :**
Receive Stop Sensing
Message 504

**STOP**

Load Change 505

**Step 808:**
Local load adaptation
requested?

Yes

No

**Step 809 :**
Receive Start Sensing
message 502'

**Step 813 :**
Receive Start Sensing
message 502'

**Step 810 :**
Perform remote loaded
measurement VRL

**Step 814 :**
Perform local loaded
measurement VLL

**Step 811 :**
Send Sensing Results
message 503' (VRL)

**Step 815 :**
Send Sensing Results
message 503' (VLL)

**Step 812 :**
Receive Stop Sensing
message 504'

**Step 816 :**
Receive Stop Sensing
message 504'

**Step 901 :**
Device startup

**Step 902 :**
Get device ID list

**Step 903 :**
Determine chosen
device

**Step 904 :**
Send/Receive Initialize
Sensing Message 501

**Step 905 :**
Send/Receive Start
Sensing message 502

**Step 906 :**
Perform unloaded
measurements VUL

**Step 907 :**
Send/Receive Sensing
Results Message 503

**Step 908 :**
Send/Receive Stop
Sensing message 504

**Step 909 :**
Select devices for load
adaptation

**Step 910 :**
Local load adaptation
requested?

Yes

No

**Step 911 :**
Receive Load Change,
Start Sensing 505, 502'

**Step 912 :**
Perform/Send Sensing
Results 503' (VRL)

**Step 913 :**
Receive Sensing
Results 503'

**Step 914 :**
Receive Stop Sensing
message 504'

**Step 915 :**
Send Load Change,
Start Sensing 505, 502'

**Step 916 :**
Perform/Send Sensing
Results 503' (VLL)

**Step 917 :**
Receive Sensing
Results 503'

**Step 918 :**
Send Stop Sensing
message 504'

No

**Step 919 :**
All load adaptation
performed?

Yes

**Step 920 :**
Determine device
order

**Step 921 :**
Compute cable
resistances

STOP

900

**Fig. 9**

Fig. 10

Fig. 11

EP 3 482 530 B1

Fig. 12

1200

Step 1201 :
Initialize method

Step 1202 :
Set p

Step 1203 :
Calculate cable resistance voltage

Step 1206 :
Increment p

Step 1205 :
Set non-compatible device detected flag to 1

Step 1204 :
VULp_cal – VULp_real > Vth?

Yes

No

Step 1207 :
Non-compatible device detected?

No

Yes

Step 1208 :
Determine position of non-compatible device

Step 1209 :
Calculate current of non-compatible device

Step 1210 :
Determine position of non-compatible device

Step 1211 :
Admission control procedure

STOP

**Fig. 13**

EP 3 482 530 B1

Fig. 14

EP 3 482 530 B1

**EP 3 482 530 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8930729 B1
- WO 2015029028 A1